# EUROPEAN PATENT APPLICATION

(11) **EP 2 278 852 A1**
(43) Date of publication of application: **26.01.2011**
(21) Application number: 09721568.5
(22) Date of filing: 17.03.2009
(51) Int. Cl.: H05B 33/02, H01L 51/50, H05B 33/10

(54) **SUBSTRATE FOR ELECTRONIC DEVICE, LAYERED BODY FOR ORGANIC LED ELEMENT, METHOD FOR MANUFACTURING THE SAME, ORGANIC LED ELEMENT, AND METHOD FOR MANUFACTURING THE SAME**

(30) Priority: 18.03.2008 JP 2008069841; 28.11.2008 JP 2008304183
(71) Applicant: Asahi Glass Company, Limited, Chiyoda-ku Tokyo 100-8405 (JP)
(72) Inventor: NAKAMURA, Nobuhiro, Tokyo 100-8405 (JP); HAYASHI, Kazutaka, Tokyo 100-8405 (JP); ISHIBASHI, Nao, Tokyo 100-8405 (JP); SERITA, Masayuki, Tokyo 100-8405 (JP)
(74) Representative: Müller-Boré & Partner Patentanwälte
(86) International application number: PCT/JP2009/055167
(87) International publication number: WO 2009/116531

(57) **Abstract**

An organic LED element having improved reliability in a long-term use, and having improved external extraction efficiency up to 80% of emitted light is provided. A substrate for an electronic device according to the present invention includes: a translucent substrate; a scattering layer including a glass and being provided on the translucent electrode; a coating layer provided on the scattering layer, and scattering materials that are present in the scattering layer and the coating layer and are not present on a surface of the coating layer, in which a surface of the coating layer has waviness in which a ratio Ra/Rλa of waviness height Ra to waviness period Rλa exceeds 1.0×10⁻⁴ and is 3.0×10⁻² or less.

## Description

### TECHNICAL FIELD

The present invention relates to an electronic device such as a light emitting element, and particularly relates to an organic LED (Organic Light Emitting Diode) element.

### BACKGROUND ART

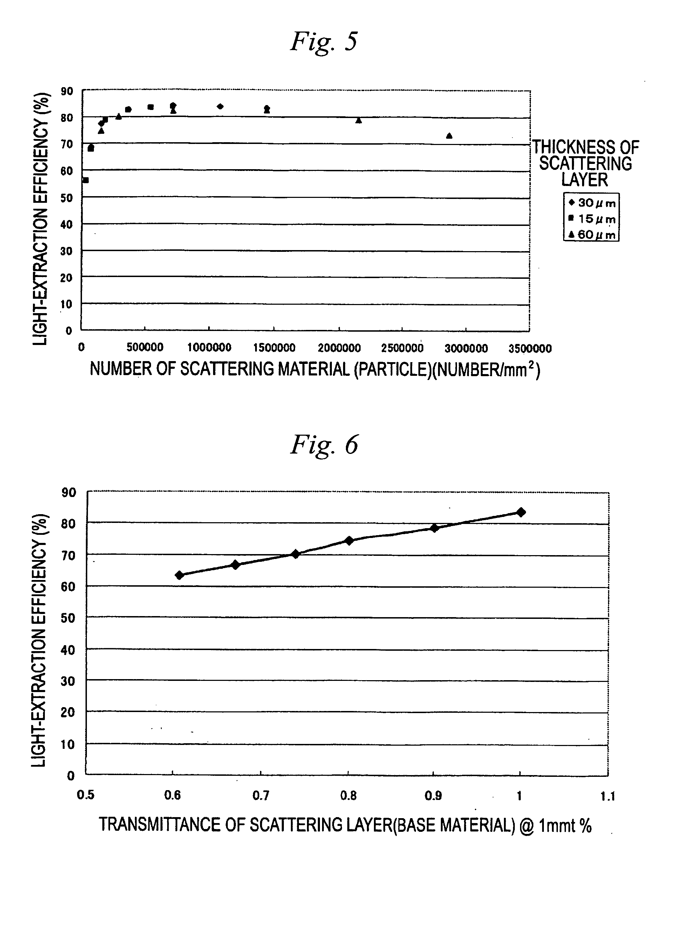

At the present, external extraction efficiency of an organic LED element is said to be about 20% of the emitted light. For this reason, increasing the external extraction efficiency is required.
Patent Documents 1 to 3 disclose that a scattering layer is provided between a translucent substrate and a translucent electrode to improve the external extraction efficiency. Patent Document 1 discloses that a surface of a scattering layer is polished and smoothened such that particles do not protrude from the surface of scattering layer as described on page 8, lines 25 to 29 of the description. Patent Documents 2 and 3 disclose that a scattering layer is constituted of two layers of a film having irregular shape and an adhesive covering the film as shown in Fig. 5b of the publications.

Patent Document 1: WO2003/026357 pamphlet
Patent Document 2: JP-T-2004-513483
Patent Document 3: JP-T-2004-513484

### DISCLOSURE OF THE INVENTION

### Problems That the Invention is to Solve

However, surface polishing of Patent Document 1 is not practical, and possibility of obtaining improvement in extraction efficiency is low. One of the reasons is that adjustment of polishing rate and specific jig are required to polish a surface of a thin resin. Other reason is that it is assumed that only particles are removed during polishing a surface of a scattering layer. As a result, plural craters due to the particles removed are present on the surface of the scattering layer, and it is assumed that emitted light cannot enter the scattering layer by the craters. Furthermore, Patent Documents 2 and 3 have reliability problem. The reason for this is that the scattering layers of Patent Documents 2 and 3 each use an adhesive. Although not clearly disclosed in those Patent Documents, an adhesive generally comprises a resin as a main component. However, the resin has a problem that the resin absorbs water due to the use over a long period of time and causes discoloration. For this reason, the resin has the problem that light extraction efficiency is decreased due to the use over a long period of time. To respond to the use over a long period of time, a step of dehydrating an organic LED element having a resin provided therein is required. This step takes several hours, resulting in deterioration of productivity. Additionally, a resin becoming an adhesive has low refractive index. For example, the Patent Documents use 3M Laminating Adhesive 8141, trade name, manufactured by Minnesota Mining and Manufacturing, and its refractive index is 1.475. As a result, refractive index of the adhesive is considerably lower than a refractive index (in the case of ITO, 1.9) of a translucent electrode, and this gives rise to the problem that improvement in extraction efficiency cannot be expected.

### Means for Solving the Problems

The substrate for an electronic device of the present invention comprises a translucent substrate; a scattering layer comprising a glass and being provided on the translucent substrate; a coating layer provided on the scattering layer; and scattering materials that are present in the scattering layer and the coating layer and are not present on a surface of the coating layer.
The laminate for an organic LED element of the present invention comprises a translucent substrate; a scattering layer comprising a glass and being provided on the translucent substrate; a coating layer provided on the scattering layer; and a plurality of scattering materials that are present across the interface between the scattering layer and the coating layer and do not protrude from a main surface of the coating layer.
A process for producing a laminate for an organic LED element of the present invention comprises the steps of: preparing a translucent substrate; forming a scattering layer comprising a glass containing a scattering material on the translucent substrate; and forming a coating layer that does not contain the scattering material on the scattering layer.
The electronic device of the present invention comprises a translucent substrate; a scattering layer comprising a glass and being provided on the translucent substrate; a coating layer provided on the scattering layer, a translucent electrode layer provided on the coating layer; a plurality of scattering materials that are present across the interface between the scattering layer and the coating layer and do not present across the interface between the translucent electrode layer and the glass layer; and a functional layer provided on the translucent electrode layer.
The organic LED element of the present invention comprises a translucent substrate; a scattering layer comprising a glass and being provided on the translucent substrate; a coating layer provided on the scattering layer; a translucent electrode layer provided on the coating layer, a plurality of scattering materials that are present across the interface between the scattering layer and the coating layer and are not present across the interface between the translucent electrode layer and the glass layer; an organic layer provided on the translucent electrode layer; and a reflective electrode provided on the organic layer.
A process for producing an organic LED element of the present invention comprises the steps of: preparing a translucent substrate; providing a scattering layer comprising a glass containing scattering materials on the translucent substrate; providing a coating layer that does not contain the scattering material on the scattering layer; providing a translucent electrode layer on the coating layer; providing an organic layer on the translucent electrode layer; and providing a reflective electrode on the organic layer.
The laminate for an organic LED element of the present invention comprises a translucent substrate; a first layer provided on the translucent substrate; a glass layer provided on the first layer; and a plurality of scattering materials that are prevent across the interface between the first layer and the glass layer and do not protrude from a main surface of the glass layer.

### Advantages of the Invention

According to the present invention, an organic LED element having improved reliability in a long-term use, and having improved external extraction efficiency up to 80% of emitted light can be provided.

### BRIEF DESCRIPTION OF THE DRAWINGS

Fig. 1 is a cross-sectional view showing structures of a laminate for an organic LED element and an organic LED element, of the present invention.
Fig. 2 is a graph showing the relationship between the light extraction efficiency (%) and the content (vol%) of a scattering material.
Fig. 3 is a graph showing the relationship between the light extraction efficiency (%) and the refractive index of a scattering material.
Fig. 4 is a graph showing the relationship between the light extraction efficiency (%) and the content (vol%) of a scattering material.
Fig. 5 is a graph showing the relationship between the light extraction efficiency (%) and the number (number/mm²) of scattering materials.
Fig. 6 is a graph showing the relationship between the light extraction efficiency (%) and the transmittance (@1 mmt%) of a base material of the scattering layer.
Fig. 7 is a graph showing the relationship between the light extraction efficiency (%) and the reflectivity (%) of a cathode.
Fig. 8 is a graph showing the relationship between the ratio of light outgoing to the scattering layer and the refractive index of the base material of the scattering layer.
Fig. 9 is a graph showing the relationship between the wavelength and the refractive index of the base material of the scattering layer.
Figs. 10 show the results of simulation of the relationship between the wavelength and the illuminance of a light receiving surface.
Fig. 11 is a cross-sectional view showing the coating layer having waviness.
Fig. 12 is a cross-sectional view of the organic LED element of the first embodiment of the present invention.
Fig. 13 is a cross-sectional view of the organic LED element of the second embodiment of the present invention.
Fig. 14 is a cross-sectional view of the organic LED element of other embodiment of the present invention.
Fig. 15 is the results of observation from the front under the conditions of. Example 1 and Example 2.
Fig. 16 is a cross-sectional view showing that a part of particles protrudes from the surface of the scattering layer.
Fig. 17 is across-sectional photograph showing that a part of particles protruded from the surface of the scattering layer are covered with the coating layer.
Fig. 18 is a view showing the measurement places.
Fig. 19 is a view showing the measurement range.
Fig. 20 is a photograph showing the light-emitting state of the organic LED element (light emitting element) that does not have the scattering layer and the coating layer.
Fig. 21 is a photograph showing the light emitting state of the light emitting element that does not have the coating layer and has the scattering layer having particles protruded from the surface thereof.
Fig. 22 is a photograph showing the light emitting state of the light emitting element that has the scattering layer and the coating layer.
Fig. 23 is a graph showing the relationship between voltage and current.
Fig. 24 is a graph showing the relationship between current and light flux.

### BEST MODE FOR CARRYING OUT THE INVENTION

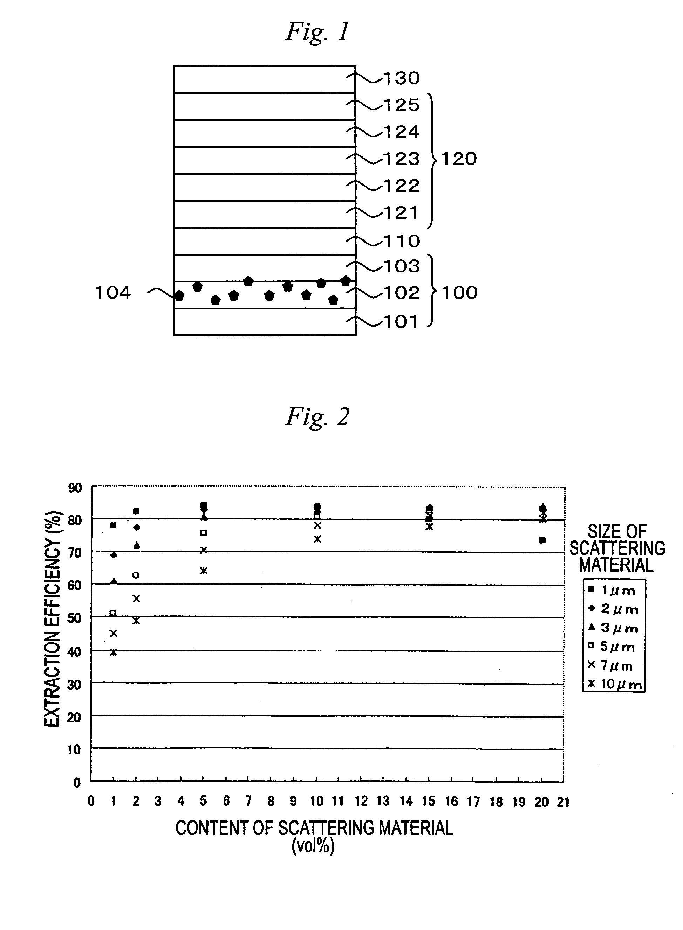

A laminate for an organic LED element as a substrate for an electronic device and an organic LED element comprising the laminate for an organic LED element, of the present invention are described below using the drawings. Fig. 1 is a cross-sectional view showing the structures of the laminate for an organic LED element and the organic LED element comprising the laminate for an organic LED element.
The organic LED element of the present invention comprises a laminate 100 for an organic LED element, a translucent electrode layer (translucent electrode) 110, an organic layer 120, and a reflective electrode 130, as shown in Fig. 1. The laminate 100 for an organic LED element comprises a translucent substrate 101, a scattering layer 102 and a coating layer 103. The scattering layer 102 contains scattering materials 104 in a base material. The organic layer 120 comprises a hole injection layer 121, a hole transport layer 122, a light-emitting layer 123, an electron transport layer 124, and an electron injection layer 125.
The present invention is described in detail below.

### Translucent Substrate

A material having high transmittance to a visible light is used as the translucent substrate. Specifically, a glass substrate or a plastic substrate is used as the material having high transmittance. Examples of a material for the glass substrate include an inorganic glass such as an alkali glass, an alkali-free glass or a quartz glass. A material for the plastic substrate includes polyester, polycarbonate, polyether, polysulfone, polyether sulfone, polyvinyl alcohol and a fluorine-containing polymer such as polyvinylidene fluoride and polyvinyl fluoride. In order to solve permeation of moisture through the substrate, the plastic substrate may be constituted such that barrier properties are given thereto.
The thickness of the translucent substrate is preferably from 0.1 mm to 2.0 mm in the case of a glass. However, too thin substrate results in a decrease in strength, so that it is particularly preferred that the thickness is from 0.5 mm to 1.0 mm.
In order to prepare the scattering layer by glass frit, a problem of strain and the like are encountered. In this case, a thermal expansion coefficient of the translucent substrate is preferably 50×10⁻⁷/°C or more, more preferably 70×10⁻⁷/°C or more and still more preferably 80×10⁻⁷/°C or more. It is preferred as the scattering layer in this case that an average thermal expansion coefficient at from 100 to 400°C is from 70×10⁻⁷/°C to 95×10⁻⁷/°C and a glass transition temperature is from 450 to 550°C.

### Scattering Layer

A constitution, a preparation method and characteristics of the scattering layer and a measuring method of the refractive index will be described in detail below. In order to realize an improvement of the light-extraction efficiency, it is preferred that the refractive index of the scattering layer is equivalent to or higher than the refractive index of a translucent electrode material, although details thereof are described later.

### Constitution

The scattering layer used comprises a base material having a main surface and high light transmittance, and particularly a scattering layer containing a scattering material in the base material is used. A glass and a crystallized glass are used as the base material. Examples of a material for the glass include an inorganic glass such as soda lime glass, borosilicate glass alkali-free glass or quartz glass. A plurality of scattering materials are formed in the base material. For example, the scattering material includes pores, precipitated crystals, particles of a material different from the base material and phase-separated glass. The particle as used herein means a small solid material, and there is a filler or a ceramic. The pore means an air or a gaseous material. The phase-separated glass means a glass constituted of two or more kinds of glass phases. When the scattering material is the pore, the size of the scattering material indicates a size of a void.
It is preferred that the scattering layer is directly formed on the translucent substrate. However, when a glass substrate is used as the translucent substrate, an alkali component contained in the glass substrate diffuses, and may give influence to the characteristics of the scattering material in the scattering layer.
In particular, when the scattering material is a fluorescent material, the fluorescent material is weak to the alkali component, and may not exhibit its characteristic.
For this reason, when a glass substrate is used as the translucent substrate, a barrier film comprising at least one layer may be formed between the glass substrate and the scattering layer. The barrier film is preferably a thin film containing at least one of oxygen and silicon.
A silicon oxide film, a silicon nitride film, a silicon oxycarbide film, a silicon oxynitride film, an indium oxide film, a zinc oxide film, a germanium oxide film and the like can be used as the thin film containing silicon or oxygen. Of those films, a film comprising silicon oxide as a main component has high translucency and is therefore more preferred.
When a plastic substrate is used as the translucent substrate, a water vapor barrier layer comprising at least one layer may be formed between the plastic substrate and the scattering layer. The water vapor barrier layer used is preferably a film containing at least one of silicon and oxygen. Silicon oxide, silicon nitride, silicon oxynitride, silicon oxycarbide, aluminum oxide, zinc oxide, indium oxide, germanium oxide and the like can be used as the thin film containing oxygen or silicon. Of those, a film comprising silicon nitride as a main component is dense and has high barrier property. Therefore, the film is more preferred. When an alkali barrier film and a water vapor barrier film have a laminate structure of thin films having the respective different refractive indexes, the light-extraction efficiency can further be improved.

An inorganic fluorescent material powder can be used as the scattering material. The inorganic fluorescent material powder includes oxide, nitride, oxynitride, sulfide, oxysulfide, halide, aluminate chloride and halophosphate chloride.

Of the above inorganic fluorescent materials, it is particularly preferred to use inorganic fluorescent materials having an excitation band in a wavelength of from 300 to 500 nm and having an emission peak in a wavelength of from 380 to 780 nm, particularly fluorescent materials emitting light in blue, green and red.
The fluorescent material emitting blue fluorescence when irradiated with excitation light of ultraviolet region having a wavelength of from 300 to 400 nm includes Sr₅(PO₄)₃Cl:Eu⁺², (Sr,Ba)MgAl₁₀O₁₇:Eu²⁺ and (Sr,Ba)₃MgSi₂O₈:Eu⁺².
The fluorescent material emitting green fluorescence when irradiated with excitation light of ultraviolet region having a wavelength of from 300 to 400 nm includes SrAl₂O₄:Eu⁺², SrGa₂S₄:Eu⁺², SrBaSiO₄:Eu⁺², CdS:In, Cas:Ce³⁺, Y3(Al,Gd)₅O₁₂:Ce²⁺, Ca₃Sc₂Si₃O₁₂:Ce³⁺SrSiOn:Eu⁺², ZnS:Al³⁺,Cu⁺, CaS:Sn²⁺, Cas:Sn²⁺,F, CaSO₄:Ce³⁺,Mn²⁺, LiAlO₂:Mn2⁺, BaMgAl₁₀O₁₇:Eu⁺²,Mn²⁺, ZnS:Cu⁺,Cl⁻, Ca₃WO₆:U, Ca₃SiO₄Cl₂:Eu⁺², SrₓBa_{y}Cl_{z}Al₂O_{4-z/2}:Ce³⁺,Mn²⁺(X:0.2, Y:0.7, Z:1.1), Ba₂MgSi₂O₇:Eu⁺², Ba₂SiO₄:Eu⁺², Ba₂Li₂Si₂O₇:Eu⁺², ZnO:S, ZnO:Zn, Ca₂Ba₂(PO₄)₃Cl:Eu⁺² and BaAl₂O₄:Eu⁺².

The fluorescent material emitting green fluorescence when irradiated with blue excitation light having a wavelength of from 440 to 480 nm includes SrAl₂O₄:Eu⁺², SrGa₂S₄:EU⁺², SrBaSiO₄:Eu⁺², CdS:In, CaS:Ce³⁺, Y₃(Al,Gd)₅O₁₂:Ce²⁺, Ca₃Sc₂SiO₃O₁₂:Ce³⁺ and SrSiO_{N}:Eu⁺².

The fluorescent material emitting yellow fluorescence when irradiated with excitation light of ultraviolet region having a wavelength of from 300 to 440 nm includes ZnS:Eu⁺², Ba₅(PO₄)₃Cl:U, Sr₃WO₆:U, CaGa₂S₄:Eu⁺², SrSO₄:Eu⁺²,Mn²⁺ and ZnS:P,ZnS:P³⁻,CrZnS:Mn²⁺.
The fluorescent material emitting yellow fluorescence when irradiated with blue excitation light having a wavelength of from 440 to 480 nm includes Y₃(Al,Gd)₅O₁₂:Ce²⁺, Ba₅(PO₄)₃Cl:U and CaGa₂S₄:Eu⁺².
The fluorescent material emitting red fluorescence when irradiated with excitation light of ultraviolet region having a wavelength of from 300 to 440 nm includes CaS:Yb²⁺,Cl, Cd₃Ga₄O₁₂:Cr⁺³, CaGa₂S₄:Mn²⁺, Na(Mg,Mn)₂LiSi₄O₁₀F₂:Mn,ZnS:Sn²⁺, Y₃Al₅O₁₀:Cr³⁺, SrB₈O₁₃:Sm²⁺, MgSr3Si2O₈:Eu²⁺,Mn²⁺, α-SrO-3B₂O₃:Sm²⁺, ZnS-CdS,ZnSe:Cu⁺,Cl, ZnGa₂S₄:Mn²⁺, ZnO:Bi³⁺, BaS:Au,K,ZnS:Pb²⁺, ZnS:Sn²⁺,Li⁺, ZnS:Pb,Cu,CaTiO₃:Pr³⁺, CaTiO₃:Eu³⁺, Y₂O₃:Eu³⁺, (Y,Gd)₂O₃:Eu³⁺, CaS:Pb²⁺,Mn²⁺, YPO₄:Eu³⁺, Ca₂MgSi₂O₇:Eu²⁺,Mn²⁺, Y(P,V)O₄:Eu³⁺, Y₂O₂:Eu³⁺, SrAl₄O₇:Eu³⁺, CaYAIO₄:EU³⁺, LaO₂S:Eu³⁺, LiW₂O₈:Eu³⁺,Sm³⁺, (Sr,Ca,Ba,Mg)₁₀(PO₄)₆Cl₂:En²⁺,Mn²⁺ and Ba₃MgSiO₂O₈:EU²⁺,Mn²⁺.
The fluorescent material emitting red fluorescence when irradiated with blue excitation light having a wavelength of from 440 to 480 nm includes ZnS:Mn²⁺,Te²⁺, Mg₂TiO₄:Mn⁴⁺, K₂SiF₆:Mn⁴⁺, SrS:Eu²⁺, Na₁₂₃K_{0.42}EU_{0.12}TiSi₄O₁₁, Na₁₂₃K_{0.42}Eu_{0.12}Tisi₅O₁₃:Eu³⁺, CdS:In,Te, CaAlSiN₃:Eu²⁺, CaSiN₃:Eu²⁺, (Ca,Sr)₂Si₅N₈:Eu²⁺ and Eu₂W₂O₇.

A plurality of inorganic fluorescent material powders may be mixed and used in conformity with wavelength region of the excitation light and color that desires to be emitted. For example, when white light is desired to obtain by irradiation with excitation light of ultraviolet region, fluorescent materials emitting blue, green and red fluorescence are mixed and used.
Of the above inorganic fluorescent material powders, there are powders that react with a glass by heating at the time of firing and cause abnormal reaction such as foaming or discoloration, and the degree becomes remarkable as the firing temperature is increased. However, even such inorganic fluorescent material powders can be used by optimizing the firing temperature and the glass composition.

Particularly, considering a screen printing method, YAG-based fluorescent material is preferred. The resin supports a glass powder and a filler in the coating film after screen printing. Specific examples of the resin used include ethyl cellulose, nitrocellulose, an acrylic resin, vinyl acetate, a butyral resin, a melamine resin, an alkyd resin and a rosin resin. The resin used as a main ingredient is ethyl cellulose and nitrocellulose. The butyral resin, melamine resin, alkyd resin and rosin resin are used as additives for improving strength of a coating film.
It is preferred to use the inorganic fluorescent material having a thermal conductivity at 25°C of 10W/m·K or more (preferably 15W/m·K or more, and more preferably 20W/m·K or more). Use of the inorganic fluorescent material increases heat release effect when the thermal conductivity of an inorganic material substrate is increased.

In order to realize an improvement of the light extraction efficiency which is the principal object of the present invention, it is preferred that the refractive index of the base material is equivalent to or higher than the refractive index of the translucent electrode material. When the refractive index is low, there is a possibility that loss due to total reflection occurs at the interface between the base material and the translucent electrode material. The refractive index of the base material is only required to exceed for at least one portion (for example, red, blue, green or the like) in the emission spectrum range of the light-emitting layer. However, it exceeds preferably over the whole region (from 430 nm to 650 nm) of the emission spectrum region, and more preferably over the whole region (from 360 nm to 830 nm) of the wavelength range of visible light.
For the same reason as above, it is preferred that the refractive index of the base material is equivalent to or higher than the refractive index of the coating layer. When direction of light entered the scattering layer from the coating layer can be changed by the scattering material present at the interface between the scattering layer and the coating layer, specifically when the refractive index of the scattering material contained in the scattering layer is higher than that of the base material of the coating layer, there is no problem even though the refractive index of the base material is lower than the refractive index of the coating layer.

Although both the refractive indexes of the scattering material and the base material may be high, the difference (Δn) in the refractive indexes is preferably 0.2 or more in at least one portion in the emission spectrum range of the light-emitting layer. The difference (Δn) in the refractive indexes is more preferably 0.2 or more over the whole region (from 430 nm to 650 nm) of the emission spectrum range or the whole region (from 360 nm to 830 nm) of the wavelength range of visible light

In order to obtain the maximum refractive index difference, a constitution of using a high refractive index glass as the high light transmittance material and a gaseous material, namely pores, as the scattering material is desirable. In this case, the refractive index of the base material is desirably high as possible, so that the high refractive index glass is preferably used as the base material. One or two or more kinds of components selected from P₂O₅, SiO₂, B₂O₃, Ge₂O and TeO₂ as a network former can be used as the components of the high refractive index glass. Furthermore, the high refractive index glass containing one or two or more kinds of components selected from TiO₂, Nb₂O₅, WO₃, Bi₂O₃, La₂O₃, Gd₂O₃, Y₂O₃, ZrO₂, ZnO, BaO, PbO and Sb₂O₃ as the high refractive index component can be used. In addition, in a sense of adjusting characteristics of the glass, an alkali oxide, an alkaline earth oxide, a fluoride or the like may be used within the range not impairing characteristics for the refractive index. Specific glass systems include a B₂O₃-ZnO-La₂O₃ system, a P₂O₅-B₂O₃-R'₂O-R"O-TiO₂-Nb₂O₅-WO₃-Bi₂O₃ system, a TeO₂-ZnO system, a B₂O₃-Bi₂O₃ system, a SiO₂-Bi₂O₃ system, a SiO₂-ZnO system, a B₂O₃-ZnO system, a P₂O₅-ZnO system and the like, wherein R' represents an alkyl metal element, and R" represents an alkaline earth metal element. The above systems are examples, and the glass system is not construed as being limited to these examples so long as it is constituted so as to satisfy the above-mentioned conditions.

It is possible to change color of light emission by allowing the base material to have a specific transmittance spectrum. As the colorant, a known colorant such as a transition metal oxide, a rare earth metal oxide and a metal colloid can be used singly or in combination thereof.
In general, white light emission is necessary for backlight and lighting applications. For whitening, there are known a method in which red, blue and green are spatially selectively coated (selective coating method), a method of laminating light-emitting layers having different light emission colors (lamination method) and a method of color changing light emitted in blue with a color changing material spatially separately provided (color changing method). In the backlight and lighting applications, what is necessary is just to uniformly obtain while color, so that the lamination method is generally used. The light-emitting layers to be laminated are used in such a combination that white color is obtained by additive color mixing. For example, a blue-green layer and an orange layer are laminated, or red, blue and green are laminated, in some cases. In particular, in the lighting applications, color reproducibility at an irradiation surface is important, so that it is desirable to have an emission spectrum necessary for a visible light region. When the blue-green layer and the orange layer are laminated, lighting of one with a high proportion of green deteriorates color reproducibility, because of low light emission intensity of green color. The lamination method has a merit that it is necessary to spatially change a color arrangement, whereas it has the following two problems. The first problem is that the emitted light extracted is influenced by interference, because the film thickness of the organic layer is thin as described above. Accordingly, color changes depending on the viewing angle. In the case of white color, such a phenomenon becomes a problem in some cases, because the sensitivity of the human eye to color is high. The second problem is that a carrier balance is disrupted during light emission to cause changes in light-emitting luminance in each color, resulting in changes in color.

The conventional organic LED element has no idea of dispersing a fluorescent material in a scattering layer, so that it cannot solve the above problem of changes in color. Accordingly, the conventional organic LED element has been insufficient yet for the backlight and lighting applications. However, in the substrate for an organic LED element and the organic LED element of the present invention, the fluorescent material can be used in the scattering material or the base material. This can cause an effect of performing wavelength conversion by light emission from the organic layer to change color. In this case, it is possible to decrease the light emission colors of the organic LED, and the emitted light is extracted after being scattered. Accordingly, the angular dependency of color and changes in color with time can be inhibited.

The surface of the scattering layer 102 on which the coating layer 103 is formed may have waviness. Wavelength Rλa of the waviness is preferably 50 µm or more. Furthermore, surface roughness Ra of the surface constituting the waviness is particularly desirably 30 nm or less.
According to this constitution, it is possible to inhibit mirror visibility. Further, it is possible to provide an electronic device which inhibits interelectrode short circuit of an electronic device formed on the surface and has long life and high effective area by controlling the wavelength and the roughness of waviness to the above range.
Furthermore, a ratio Ra/Rλa of surface roughness Ra of the surface constituting waviness to wavelength Rλa of waviness on the surface preferably exceeds 1.0×10⁻⁴ and is 3.0×10⁻² or less.

When Rλa is large to such an extent that (Ra/Rλa) is less than 1.0×10⁻⁴ or the waviness roughness Ra is small, mirror reflectivity cannot sufficiently be reduced. Further, when the waviness roughness is large to such an extent that the ratio (Ra/Rλa) exceeds 3.0×10⁻², it is difficult to form a device because the organic layer cannot uniformly be film-formed, for example, in forming the organic LED element. The term "exceed" means to be large beyond the value.

### Preparation of Scattering Layer

The preparation method of the scattering layer uses the conventional method such as a sol-gel method, a vapor deposition method or a sputtering method. In particular, a method of preparing the layer by using a frit-pasted glass is preferred from the viewpoint of forming rapidly and uniformly a film thickness of from 10 to 100 µm with a large area. In order to utilize a frit paste method, it is desirable that the softening point (Ts) of the glass of the scattering layer is lower than the strain point (SP) of the substrate glass, and that the difference in the thermal expansion coefficient α is small, for inhibiting thermal deformation of the substrate glass. The difference between the softening point and the strain point is preferably 30°C or more, and more preferably 50°C or more. Further, the difference in the expansion coefficient between the scattering layer and the substrate glass is preferably +10×10⁻⁷ (1/K) or less, and more preferably ±5x10⁻⁷ (1/K) or less. The frit paste used herein indicates one in which a glass powder is dispersed in a resin, a solvent, a filler or the like. Glass layer coating becomes possible by patterning the frit paste using a pattern forming technique such as screen printing and firing it. The technical outline will be described below.

### Frit Paste Material

### 1. Glass Powder

The particle size of the glass powder is from 1 µm to 10 µm. In order to control the thermal expansion of the film fired, a filler is incorporated in some cases. Specifically, zircon, silica, alumina or the like is used as the filler, and the particle size thereof is from 0.1 µm to 20 µm.

### Glass materials will be described below.

The glass composition for forming the scattering layer is not particularly limited so long as desired scattering characteristics are obtained and it can be frit-pasted and fired. In order to maximize the extraction efficiency, examples thereof include a system containing P₂O₅ as an essential component and one or more components of Nb₂O₅, Bi₂O₃, TiO₂ and WO₃; a system containing B₂O₃ and La₂O₃ as essential components and one or more components of Nb₂O₅, ZrO₂, Ta₂O₅ and WO₃; a system containing SiO₂ as an essential component and one or more components of Nb₂O₅ and TiO₂; a system containing Bi₂O₃ as a main component and SiO₂, B₂O₃ and the like as network forming components; and the like.

In all glass systems used as the scattering layer in the present invention, As₂O₃, PbO, CdO, ThO₂ and HgO which are components having adverse effects on the environment are not contained, except for the case of inevitable contamination therewith as impurities derived from raw materials.
When the scattering layer has low refractive index, the glass system may be a system containing R₂O-RO-BaO-B₂O₃-SiO₂, a system containing RO-Al₂O₃-P₂O₅; or a system containing R₂O-B₂O₃-SiO₂, wherein R₂O is selected from Li₂O, Na₂O and K₂O, and RO is selected from MgO, CaO and SrO.

### This is specifically described below.

The scattering layer containing P₂O₅ as an essential component and one or more components of Nb₂O₅, Bi₂O₃, TiO₂ and WO₃ is preferably a glass within the composition range of 15 to 30% of P₂O₅, 0 to 15% of SiO₂, 0 to 18% of B₂O₃, 5 to 40% of Nb₂O₅, 0 to 15% of TiO₂, 0 to 50% of WO₃, 0 to 30% of Bi₂O₃, provided that the total amount of Nb₂O₅, TiO₂, WO₃ and Bi₂O₃ is from 20 to 60%, 0 to 20% of Li₂O, 0 to 20% of Na₂O, 0 to 20% of K₂O, provided that the total amount of Li₂O, Na₂O and K₂O is from 5 to 40%, 0 to 10% of MgO, 0 to 10% of CaO, 0 to 10% of SrO, 0 to 20% of BaO, 0 to 20% of ZnO and 0 to 10% of Ta₂O₅, in terms of mol%.

### Effects of the respective components are as follows in terms of mol%.

P₂O₅ is an essential component having the characteristic of forming a skeleton of a glass system and performing vitrification. The content of P₂O₅ is preferably 15% or more, and more preferably 18% or more. On the other hand, the content of P₂O₅ is preferably 30% or less, and more preferably 28% or less.
B₂O₃ is an optional component having the characteristics of improving resistance to devitrification and decreasing the thermal expansion coefficient by adding to the glass. The content of B₂O₃ is preferably 18% or less, and more preferably 15% or less.
SiO₂ is an optional component having the characteristics of stabilizing the glass and improving resistance to devitrification by adding in a slight amount. The content of SiO₂ is preferably 15% or less, more preferably 10% or less, and particularly preferably 8% or less.
Nb₂O₅ is an essential component having the characteristics of improving the refractive index and enhancing weather resistance. The content of Nb₂O₅ is preferably 5% or more, and more preferably 8% or more. On the other hand, the content of Nb₂O₅ is preferably 40% or less, and more preferably 35% or less.
TiO₂ is an optional component having the characteristic of improving the refractive index. The content of TiO₂ is preferably 15% or less, and more preferably 13% or less.
WO₃ is an optional component having the characteristics of improving the refractive index and decreasing the glass transition temperature to decrease the firing temperature. The content of WO₃ is preferably 50% or less, and more preferably 45% or less.
Bi₂O₃ is an optional component having the characteristic of stabilizing the glass while improving the refractive index. The content of Bi₂O₃ is preferably 30% or less, and more preferably 25% or less.

In order to increase the refractive index, at least one component of Nb₂O₅, TiO₂, WO₃ and Bi₂O₃ must be necessarily contained. Specifically, the total amount of Nb₂O₅, TiO₂, WO₃ and Bi₂O₃ is preferably 20% or more, and more preferably 25% or more. On the other hand, the total amount of Nb₂O₅, TiO₂, WO₃ and Bi₂O₃ is preferably 60% or less, and more preferably 55% or less.
Ta₂O₅ is an optional component having the characteristic of improving the refractive index. The content of Ta₂O₅ is preferably 10% or less, and more preferably 5% or less.

The alkali metal oxides (R₂O) such as Li₂O, Na₂O and K₂O have the characteristics of improving meltability to decrease the glass transition temperature and enhancing affinity with the glass substrate to increase adhesion. For this reason, it is desirable to contain one or two or more kinds of these. The total amount of Li₂O, Na₂O and K₂O is desirably 5% or more, and more preferably 10% or more. On the other hand, the total amount of Li₂O, Na₂O and K₂O is preferably 40% or less, and more preferably 35% or less.
Li₂O has the characteristics of decreasing the glass transition temperature and improving solubility. The content of Li₂O is preferably 20% or less, and more preferably 15% or less.
Both Na₂O and K₂O are optional components having the characteristic of improving meltability. Each content of Na₂O and K₂O is preferably 20% or less, and more preferably 15% or less.
ZnO has the characteristics of improving the refractive index and decreasing the glass transition temperature. The content of ZnO is preferably 20% or less, and more preferably 18% or less.
BaO has the characteristics of improving the refractive index and improving solubility. The content of BaO is preferably 20% or less, and more preferably 18% or less.
MgO, CaO and SrO are optional components having the characteristic of improving meltability. The respective contents of MgO, CaO and SrO are 10% or less, and more preferably 8% or less.
In order to obtain the high refractive index and stable glass, the total amount of all of the components described above is preferably 90% or more, more preferably 93% or more, and particularly preferably 95% or more.

In addition to the components described above, a refining agent, a vitrification enhancing component, a refractive index adjusting component, a wavelength converting component or the like may be added in small amounts within the range not impairing necessary glass characteristics. Specifically, Sb₂O₃ and SnO₂ are preferred as the refining agent. GeO₂, Ga₂O₃ and In₂O₃ are preferred as the vitrification enhancing component. ZrO₂, Y₂O₃, La₂O₃, Gd₂O₃ and Yb₂O₃ are preferred as the refractive index adjusting component. Rare earth components such as CeO₂, Eu₂O₃ and Er₂O₃ are preferred as the wavelength converting component.

The scattering layer containing B₂O₃ and La₂O₃ as essential components and one or more components of Nb₂O₅, ZrO₂, Ta₂O₅ and WO₃ is preferably a glass within a composition range of: 20 to 60% of B₂O₃, 0 to 20% of SiO₂, 0 to 20% of Li₂O, 0 to 10% of Na₂O, 0 to 10% of K₂O, 5 to 50% of ZnO, 5 to 25% of La₂O₃, 0 to 25% of Gd₂O₃, 0 to 20% of Y₂O₃, 0 to 20% of Yb₂O₃, provided that the total amount of La₂O₃, Gd₂O₃, Y₂O₃ and Yb₂O₃ is 5 to 30%, 0 to 15% of ZrO₂, 0 to 20% of Ta₂O₅, 0 to 20% of Nb₂O₅, 0 to 20% of WO₃, 0 to 20% of Bi₂O₃ and 0 to 20% of BaO.

### Effects of the respective components are as follows in terms of mol%.

B₂O₃ is a network forming oxide and is an essential component in this glass system. The content of B₂O₃ is preferably 20% or more, and more preferably 25% or more. On the other hand, the content of B₂O₃ is preferably 60% or less, and more preferably 55% or less.
SiO₂ is a component having the characteristic of improving stability of the glass when added to the glass of this system. The content of SiO₂ is preferably 20% or less, and more preferably 18% or less.
Li₂O is a component having the characteristic of decreasing the glass transition temperature. The content of Li₂O is preferably 20% or less, and more preferably 18% or less.
Na₂O and K₂O are components having the characteristic of improving solubility. Each content of Na₂O and K₂O is preferably 10% or less, and more preferably 8% or less.
ZnO is an essential component having the characteristics of improving the refractive index of the glass and decreasing the glass transition temperature. The content of ZnO is preferably 5% or more, and more preferably 7% or more. On the other hand, the content of ZnO is preferably 50% or less, and more preferably 45% or less.
La₂O₃ is an essential component having the characteristics of achieving high refractive index and improving weather resistance when introduced into the B₂O₃ system glass. The content of La₂O₃ is 5% or more, and more preferably 7% or more. On the other hand, the content of La₂O₃ is preferably 25% or less, and more preferably 22% or less.
Gd₂O₃ is a component having the characteristics of achieving high refractive index, improving weather resistance when introduced into the B₂O₃ system glass and improving stability of the glass by coexistence with La₂O₃. The content of Gd₂O₃ is preferably 25% or less, and more preferably 22% or less.
Y₂O₃ and Yb₂O₃ are components having the characteristics of achieving high refractive index, improving weather resistance when introduced into the B₂O₃ system glass and improving stability of the glass by coexistence with La₂O₃. Each content of Y₂O₃ and Yb₂O₃ is preferably 20% or less, and more preferably 18% or less.
The rare earth oxides exemplified by La₂O₃, Gd₂O₃, Y₂O₃ and Yb₂O₃ are essential components having the characteristics of achieving high refractive index and improving weather resistance of the glass. The total amount of La₂O₃, Gd₂O₃, Y₂O₃ and Yb₂O₃ is 5% or more, and more preferably 8% or more. On the other hand, the total amount of La₂O₃, Gd₂O₃, Y₂O₃ and Yb₂O₃ is preferably 30% or less, and more preferably 25% or less.
ZrO₂ is a component having the characteristic of improving the refractive index. The content of ZrO₂ is preferably 15% or less, and more preferably 10% or less.
Ta₂O₅ is a component having the characteristic of improving the refractive index. The content of Ta₂O₅ is preferably 20% or less, and more preferably 15% or less.
Nb₂O₅ is a component having the characteristic of improving the refractive index. The content of Nb₂O₅ is preferably 20% or less, and more preferably 15% or less.
WO₃ is a component having the characteristic of improving the refractive index. The content of WO₃ is preferably 20% or less, and more preferably 15% or less.
Bi₂O₃ is a component having the characteristic of improving the refractive index. The content of Bi₂O₃ is preferably 20% or less, and more preferably 15% or less.
BaO is a component having the characteristic of improving the refractive index. The content of BaO is preferably 20% or less, and more preferably 15% or less.
In order to obtain the high refractive index and stable glass, the total amount of all of the components described above is preferably 90% or more, and more preferably 95% or more.
In addition to the components described above, other components may be added within the range not impairing the effect of the present invention for the purpose of refining, improvement of solubility, and the like. Such components include, for example, Sb₂O₃, SnO₂, MgO, CaO, SrO, GeO₂, Ga₂O₃, In₂O₃ and fluorine.

The scattering layer containing SiO₂ as an essential component and one or more components of Nb₂O₅, TiO₂ and Bi₂O₃ is preferably a glass within the composition range of 20 to 50% of SiO₂, 0 to 20% of B₂O₃, 1 to 20% of Nb₂O₅, 1 to 20% of TiO₂, 0 to 15% of Bi₂O₃, 0 to 15% of ZrO₂, the total amount of Nb₂O₃, TiO₂, Bi₂O₃ and ZrO₂ is 5 to 40%, 0 to 40% of Li₂O, 0 to 30% of Na₂O, 0 to 30% of K₂O, the total amount of Li₂O, Na₂O and K₂O is 1 to 40%, 0 to 20% of MgO, 0 to 20% of CaO, 0 to 20% of SrO, 0 to 20% of BaO and 0 to 20% of ZnO, in terms mol%.
SiO₂ is an essential component having the characteristic of acting as a network former for forming the glass. The content of SiO₂ is preferably 20% or more, and more preferably 22% or more.
Bi₂O₃ is a component having the characteristic of assisting glass formation when added to the glass containing SiO₂ in a small amount, thereby decreasing devitrification. The content of Bi₂O₃ is preferably 20% or less, and more preferably 18% or less.
Nb₂O₅ is an essential component having the characteristic of improving the refractive index. The content of Nb₂O₅ is preferably 1% or more, and more preferably 3% or more. On the other hand, the content of Nb₂O₅ is preferably 20% or less, and more preferably 18% or less.
TiO₂ is an essential component having the characteristic of improving the refractive index. The content of TiO₂ is preferably 1% or more, and more preferably 3% or more. On the other hand, the content of TiO₂ is preferably 20% or less, and more preferably 18% or less.
Bi₂O₃ is an essential component having the characteristic of improving the refractive index. The content of Bi₂O₃ is preferably 15% or less, and more preferably 12% or less.
ZrO₂ is a component having the characteristic of improving the refractive index without deteriorating the degree of coloring. The content of ZrO₂ is preferably 15% or less, and more preferably 10% or less.
The total amount of Nb₂O₅, TiO₂, Bi₂O₃ and ZrO₂ is preferably 5% or more, and more preferably 8% or more. On the other hand, the total amount of Nb₂O₅, TiO₂, Bi₂O₃ and ZrO₂ is preferably 40% or less, and more preferably 38% or less.
Li₂O, Na₂O and K₂O are components having the characteristics of improving solubility and additionally decreasing the glass transition temperature. The total amount of Li₂O, Na₂O and K₂O is preferably 1% or more, and more preferably 3% or more. On the other hand, the total amount of Li₂O, Na₂O and K₂O is preferably 40% or less, and more preferably 35% or less.
BaO is a component having the characteristic of improving the refractive index and at the same time, improving solubility. The content of BaO is preferably 20% or less, and more preferably 15% or less.
MgO, CaO, SrO and ZnO are components having the characteristic of improving solubility of the glass. The contents of MgO, CaO, SrO and ZnO each are preferably 20% or less, and more preferably 15% or less.
In order to conform to the object of the present invention, the total amount of the components described above is desirably 90% or more. A component other than the above components may be added for the purposes of refining or an improvement of solubility, so long as it does not impair the advantages of the present invention. Such components include, for example, Sb₂O₃, SnO₂, GeO₂, Ga₂O₃, In₂O₃, WO₃, Ta₂O₅, La₂O₃, Gad₂O₃, Y₂O₃ and Yb₂O₃.

The scattering layer containing Bi₂O₃ as an essential component and SiO₂ and B₂O₃ is preferably a glass within the composition range of 10 to 50% of Bi₂O₃, 1 to 40% of B₂O₃, 0 to 30% of SiO₂, provided that the total amount of B₂O₃ and SiO₂ is from 10 to 40%, 0 to 20% of P₂O₅, 0 to 15% of Li₂O, 0 to 15% of Na₂O, 0 to 15% of K₂O, 0 to 20% of TiO₂, 0 to 20% of Nb₂O₅, 0 to 20% of TeO₂, 0 to 10% of MgO, 0 to 10% of CaO, 0 to 10% of SrO, 0 to 10% of BaO, 0 to 10% of GeO₂ and 0 to 10% of Ga₂O₃, in terms of mol%.

### Effects of the respective components are as follows in terms of mol%.

Bi₂O₃ is an essential component having the characteristics of achieving high refractive index and stably forming the glass even when introduced in a large amount. The content of Bi₂O₃ is preferably 10% or more, and more preferably 15% or more. On the other hand, the content of Bi₂O₃ is preferably 50% or less, and more preferably 45% or less.
B₂O₃ is an essential component having the characteristic of acting as a network former in the glass containing a large amount of Bi₂O₃ to assist glass formation. The content of B₂O₃ is preferably 1% or more, and more preferably 3% or more. On the other hand, the content of B₂O₃ is preferably 40% or less, and more preferably 38% or less.
SiO₂ is a component having the characteristic of assisting glass formation with Bi₂O₃ as a network former. The content of SiO₂ is preferably 30% or less, and more preferably 25% or less.
B₂O₃ and SiO₂ are components having the characteristic of improving glass formation by a combination thereof. The total amount of B₂O₃ and SiO₂ is preferably 5% or more, and more preferably 10% or more. On the other hand, the total amount of B₂O₃ and SiO₂ is preferably 40% or less, and more preferably 38% or less.
P₂O₅ is a component having the characteristics of assisting glass formation and additionally inhibiting deterioration of the degree of coloring. The content of P₂O₅ is preferably 20% or less, and more preferably 18% or less.
Li₂O, Na₂O and K₂O are components having the characteristics of improving glass solubility and additionally decreasing the glass transition temperature. The respective contents of Li₂O, Na₂O and K₂O are each preferably 15% or less, and more preferably 13% or less. On the other hand, the respective contents of Li₂O, Na₂O and K₂O are each preferably 30% or less, and more preferably 25% or less.
TiO₂ is a component having the characteristic of improving the refractive index. The content of TiO₂ is preferably 20% or less, and more preferably 18% or less.
Nb₂O₅ is a component having the characteristic of improving the refractive index. The content of Nb₂O₅ is preferably 20% or less, and more preferably 18% or less.
TeO₂ is a component having the characteristic of improving the refractive index without deteriorating the degree of coloring. The content of TeO₂ is preferably 20% or less, and more preferably 15% or less.
GeO₂ is a component having the characteristic of improving stability of the glass while maintaining the refractive index relatively high. The content of GeO₂ is preferably 10% or less, and more preferably 8% or less. GeO₂ is an expensive component. For this reason, in the case of considering costs, there is the choice that GeO₂ is not contained.
Ga₂O₃ is a component having the characteristic of improving stability of the glass while maintaining the refractive index comparatively high. The content of Ga₂O₃ is preferably 10% or less, and more preferably 8% of less. Ga₂O₃ is an expensive component. For this reason, in the case of considering costs, there is the choice that Ga₂O₃ is not contained.
In order to sufficient scattering characteristic, the total amount of the components described above is desirably 90% or more, and more preferably 95% or more. A component other than the above components may be added for the purposes of refining, an improvement of solubility, adjustment of the refractive index, and the like so long as it does not impair the advantages of the present invention. Such components include, for example, Sb₂O₃, SnO₂, In₂O₃, ZrO₂, WO₃, Ta₂O₅, La₂O₃, Gd₂O₃, Y₂O₃, Yb₂O₃ and Al₂O₃.

### 2. Resin

The resin supports the glass powder and the filler in the coating film after screen printing. Specific examples of the resin used include ethyl cellulose, nitrocellulose, an acrylic resin, vinyl acetate, a butyral resin, a melamine resin, an alkyd resin and a rosin resin. Resins used as base resins are ethyl cellulose and nitrocellulose. A butyral resin, a melamine resin, an alkyd resin and a rosin resin are used as additives for improving coating film strength. The debinderizing temperature at the time firing is from 350°C to 400°C for ethyl cellulose and from 200°C to 300°C for nitrocellulose.

### 3. Solvent

The solvent dissolves the resin and adjusts the viscosity necessary for printing. The solvent does not dry during printing and rapidly dries in a drying process. The solvent having a boiling point of from 200°C to 230°C is desirable. A mixture of some solvents is used for adjustment of the viscosity, the solid content ratio and the drying rate. From the drying adaptability of a paste at the time of screen printing, specific examples of the solvent include ether type solvents (butyl carbitol (BC), butyl carbitol acetate (BCA), diethylene glycol di-n-butyl ether, dipropylene glycol butyl ether, tripropylene glycol butyl ether and butyl cellosolve acetate), alcohol type solvents (α-terpineol, pine oil and Dowanol), ester type solvents (2,2,4-briemthyl-1,3-pentanediol monoisobutyrate) and phthalic acid ester type solvents (DBP (dibutyl phthalate, DMP (dimethyl phthalate) and DOP (dioctyl phthalate)). Solvents mainly used are α-terpineol and 2,2,4-triemthyl-1,3-pentanediol monoisobutyrate. DBP (dibutyl phthalate), DMP (dimethyl phthalate) and DOP (dioctyl phthalate) further function as a plasticizer.

### 4. Others

A surfactant may be used for viscosity adjustment and frit dispersion promotion. A silane coupling agent may be used for frit surface modification.

### Preparation Method of Frit Paste Film

### (1) Frit Paste

A glass powder and a vehicle are prepared. The vehicle used herein means a mixture of a resin, a solvent and a surfactant. Specifically, it is obtained by putting the resin, the surfactant, and the like in the solvent heated to 50°C to 80°C, and then allowing the resulting mixture to stand for about 4 hours to about 12 hours, followed by filtering.
The glass powder and the vehicle are mixed by a planetary mixer, and then uniformly dispersed with a three-roll mill. Thereafter, the resulting mixture is kneaded by a kneader for viscosity adjustment. Usually, the vehicle is used in an amount of from 20 to 30 wt% based on 70 to 80 wt% of the glass material.

### (2) Printing

The frit paste prepared in (1) is printed by using a screen printer. The film thickness of a frit paste film formed can be controlled by the mesh roughness of a screen plate, the thickness of an emulsion, the pressing force in printing, the squeegee pressing amount, and the like. After printing, drying is performed in a firing furnace.

### (3) Firing

A substrate printed and dried is fired in a firing furnace. The firing comprises debinderizing treatment for decomposing and disappearing the resin and firing treatment for sintering and softening the glass powder. The debinderizing temperature is from 350°C to 400°C for ethyl cellulose and from 200°C to 300°C for nitrocellulose. Heating is carried out in the atmosphere for from 30 minutes to 1 hour. The temperature is then raised to sinter and soften the glass. The firing temperature is from the softening temperature to (the softening temperature + 200°C), and the shape and size of pores remaining in the inside vary depending on the treatment temperature. Thereafter, cooling is carried out to form a glass film on the substrate. The thickness of the film obtained is from 5 µm to 30 µm, but thicker glass film can be formed by lamination printing.
When a doctor blade printing method or a die coat printing method is used in the above printing process, it becomes possible to form a thicker film (green sheet printing). A film is formed on a PET film or the like, and dried, thereby forming a green sheet. The green sheet is then heat pressed on the substrate by a roller or the like, and a fired film is obtained through a firing procedure similar to that of the frit paste. The thickness of the film obtained is from 50 µm to 400 µm. However, it becomes possible to form a thicker glass film by using the green sheets laminated.

### Density of Scattering Material in Scattering Layer and Size of Scattering Material

Fig. 2 is a graph showing the relationship between the light extraction efficiency (%) and the content (vol%) of a scattering material. In the following, for simplicity, calculation was made dividing the organic layer and the reflective electrode into three parts, the electron injection/transport layer and the light-emitting layer; the hole injection/transport layer; and the translucent electrode. In the graph of Fig. 2, calculation was made for the electron injection/transport layer (thickness: 1 µm, refractive index: 1.9), the coating layer (thickness: 1 µm, refractive index of base material: 1.9), the light-emitting layer (thickness: 1 µm, refractive index: 1.9), the hole injection/transport layer (thickness: 1 µm, refractive index: 1.9), the scattering layer (Thickness: 30 µm, refractive index of base material: 1.9, refractive index of scattering material: 1.0), the translucent substrate (thickness: 100 µm, refractive index: 1.54), and the light flux 1000 1m divided into 100,000 rays (wavelength: 550 nm). As shown in the graph, the content of the scattering material in the scattering layer is preferably 1 vol% or more. Although the behavior varies depending on the size of the scattering material, when the content of the scattering material in the scattering layer is 1 vol%, the light extraction efficiency can be nearly 40% or more. When the content of the scattering material in the scattering layer is 5 vol% or more, the light extraction efficiency can be 65% or more. This is therefore more preferred. When the content of the scattering material in the scattering layer is 10 vol% or more, the light extraction efficiency can be improved to 70% or more. This is still more preferred. Furthermore, when the content of the scattering material in the scattering layer is approximately 15 vol%, the light extraction efficiency can be improved to nearly 80% or more. This is therefore particularly preferred. In view of mass production of the scattering layers, the content is preferably from 10 vol% to 15 vol% at which it is difficult to be affected by production variations.

The graph further shows the relationship between the size of the scattering material and the light extraction efficiency. Specifically, in the case where the size of the scattering material is 1 µm, the light extraction efficiency can be 70% or more even when the content of the scattering material is a range of from 1 vol% to 20 vol%. In particular, when the content of the scattering material is a range of from 2 vol% to 15 vol%, the light extraction efficiency can be 80% or more. Furthermore, in the case where the size of the scattering material is 2 µm, the light extraction efficiency can be 65% or more even when the content of the scattering material is a range of from 1 vol% to 20 vol%. In particular, when the content of the scattering material is 5 vol% or more, the light extraction efficiency can be 80% or more. Furthermore, in the case where the size of the scattering material is 3 µm, the light extraction efficiency can be 60% or more even when the content of the scattering material is a range of from 1 vol% to 20 vol%. In particular, when the content of the scattering material is 5 vol% or more, the Light extraction efficiency can be 80% or more. Furthermore, in the case where the size of the scattering material is 5 µm, the light extraction efficiency can be 50% or more even when the content of the scattering material is a range of from 1 vol% to 20 vol%. In particular, when the content of the scattering material is 10 vol% or more, the light extraction efficiency can be 80% or more. Furthermore, in the case where the size of the scattering material is 7 µm the light extraction efficiency can be nearly 45% or more even when the content of the scattering material is a range of from 1 vol% to 20 vol%. In particular, when the content of the scattering material is 10 vol% or more, the light extraction efficiency can be nearly 80% or more. Furthermore, in the case where the size of the scattering material is 10 µm, the light extraction efficiency can be nearly 40% or more even when the content of the scattering material is a range of from 1 vol% to 20 vol%. In particular, when the content of the scattering material is 15 vol% or more, the light extraction efficiency can be nearly 80% or more. The above shows that when the size of the scattering material is large, the light extraction efficiency is improved with an increase in the content. On the other hand, it is seen that when the size of the scattering material is small, the light extraction efficiency is improved even in the case where the content thereof is small.

The density p₁₁ of the scattering material at a half thickness (δ/2) of the scattering layer and the density ρ₁₂ of the scattering material at a distance x (δ/2<x≤δ) from the back of the scattering layer facing the translucent substrate satisfy ρ₁₁≥ρ₁₂. Furthermore, the density ρ₁₃ of the scattering material at a distance x (x≤0.2 µm) from the surface of the scattering layer facing the coating layer and the density ρ₁₄ of the scattering material at a distance x=2 µm satisfy ρ₁₄>ρ₁₃.

### Refractive Index of Scattering Material

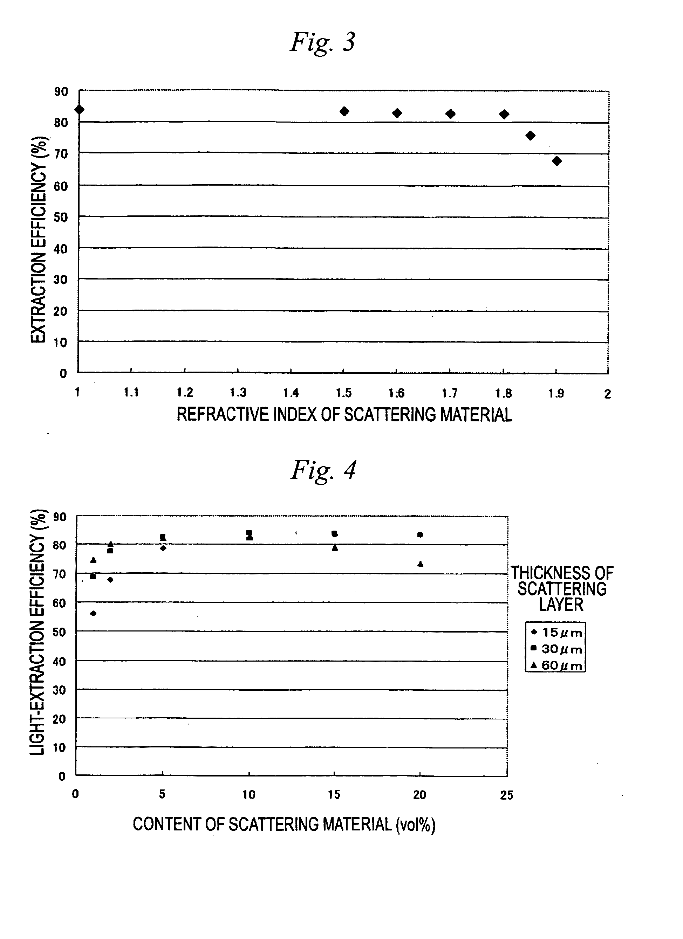

Fig. 3 is a graph showing the relationship between the light extraction efficiency (%) and the refractive index of a scattering material. In the following, for simplicity, calculation was made diving the organic layer and the reflective electrode into three parts, the electron injection/transport layer and the light-emitting layer, the hole injection/transport layer; and the translucent electrode. In the above graph, calculation was made for the electron injection/transport layer (thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm, refractive index of base material: 2.0), the scattering layer (thickness: 30 µm, refractive index of base material: 2.0, size of scattering material: 2 µm, the number of scattering materials: about 36,000,000, content of scattering material: 15 vol%), the translucent substrate (thickness: 100 µm, refractive index: 1.54), and the light flux 1000 lm divided into 100,000 rays (wavelength: 550 nm). As shown in the graph, when the difference between the refractive index (2.0) of the base material and the refractive index of the scattering material is 0.2 or more (the refractive index of the scattering material is 1.8 or less), the light extraction efficiency can be 80% or more. This is therefore particularly preferred. Even when the difference between the refractive index of the base material and the refractive index of the scattering material is 0.1 (the refractive index of the scattering material is 1.9), the light extraction efficiency can be 65% or more.

### Thickness of Scattering Layer

Fig. 4 is a graph showing the relationship between the light extraction efficiency (%) and the content of a scattering material. In the following, for simplicity, calculation was made diving the organic layer and the reflective electrode into three parts, the electron injection/transport layer and the light-emitting layer, the hole injection/transport layer; and the translucent electrode. In the above graph, calculation was made for the electron injection/transport layer (Thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm, refractive index of base material: 2.0), the scattering layer (refractive index of base material: 2.0, size of scattering material: 2 µm, refractive index of scattering material: 1.0), the translucent substrate (thickness: 100 µm, refractive index: 1.54), and the light flux 1000 lm divided into 100,000 rays (wavelength: 550 nm). As shown in the graph, when the content of the scattering material in the scattering layer is 1 vol% or more, the light extraction efficiency can be 55% or more even when the thickness of the scattering layer is 15 µm or less. This is therefore preferred. When the content of the scattering material in the scattering layer is 20 vol% or more, the light extraction efficiency can be 70% or more even when the thickness of the scattering layer is 60 µm or more. This is therefore preferred. When the content of the scattering material in the scattering layer is from 5 vol% to 15 vol%, the light extraction efficiency can be nearly 80% or more even when the thickness of the scattering layer is 15 µm or less or 60 µm or more. This is therefore particularly preferred.

### Number of Scattering Materials

Fig. 5 is a graph showing the relationship between the light extraction efficiency (%) and the number (number/mm²) of scattering materials (particles). In the following, for simplicity, calculation was made diving the organic layer and the reflective electrode into three parts, the electron injection/transport layer and the light-emitting layer, the hole injection/transport layer, and the translucent electrode. In the above graph, calculation was made for the electron injection/transport layer (thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm, refractive index of base material: 2.0), the scattering layer (refractive index of base material: 2.0, size of scattering material: 2 µm, refractive index of scattering material: 1.0), the translucent substrate (thickness: 100 µm, refractive index: 1.54), and the light flux 1000 lm divided into 100,000 rays (wavelength: 550 nm). As shown in the graph, it is seen that the light extraction efficiency varies depending on the number of the scattering materials, regardless of the thickness of the scattering layer. As shown in the graph, when the number of the scattering materials per 1 mm² of the scattering layer is 1x10⁴ or more, the light extraction efficiency can be 55% or more. This is therefore preferred. When the number of the scattering materials per I mm² of the scattering layer is 2.5x10⁵ or more, the light extraction efficiency can be 75% or more. This is therefore more preferred. When the number of the scattering materials per 1 mm² of the scattering layer is from 5x10⁵ to 2x10⁶, the light extraction efficiency can be 80% or more. This is therefore particularly preferred. Even when the size of the scattering material 60 µm or more and the number of the scattering materials is 3x10⁶, the light extraction efficiency can be 70% or more.

### Transmittance of Base Material of Scattering Layer

Fig. 6 is a graph showing the relationship between the light extraction efficiency (%) and the transmittance at 1 mmt% of a base material of the scattering layer. In the following, for simplicity, calculation was made diving the organic layer and the reflective electrode into three parts, the electron injection/transport layer and the light-emitting layer; the hole injection/transport layer; and the translucent electrode. In the above graph, calculation was made for the electron injection/transport layer (thickness: 1 µm, refractive index: 1.9), the light-emitting layer (thickness: 1 µm, refractive index: 1.9), the bole injection/transport layer (thickness: 1 µm, refractive index: 1.9), the coating layer (thickness: 1 µm, refractive index of base material: 2.0), the scattering layer (thickness: 30 µm, refractive index of base material: 2.0, size of scattering material: 2 µm, refractive index of scattering material: 1.0, the number of scattering materials: about 36,000,000, content of scattering material: 15 vol%), the translucent substrate (thickness: 100 µm, refractive index: 1.54), and the light flux 1000 lm divided into 100,000 rays. As shown in the graph, even when the transmittance of the base material of the scattering layer is 50%, the light extraction efficiency can be 55% or more. When the transmittance of the base material of the scattering layer is 90%, the light extraction efficiency can be 80% or more. When a glass is used as the base material, the transmittance is about 98%. Accordingly, the light extraction efficiency can exceed 80%.

### Reflectivity of Cathode

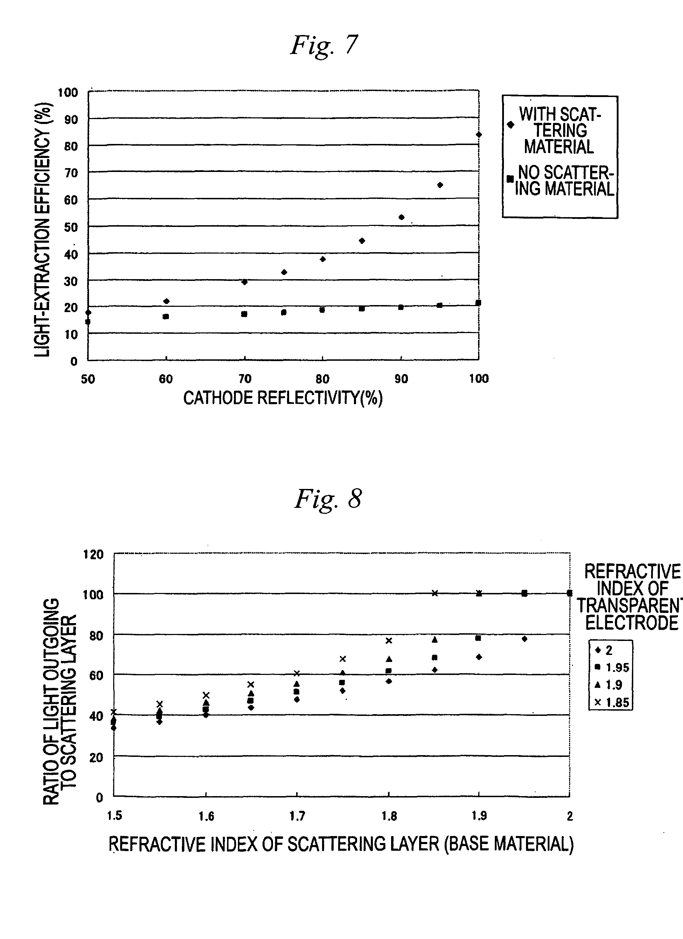

Fig. 7 is a graph showing the relationship between the light extraction efficiency (%) and the reflectivity (%) of the cathode. In the following, for simplicity, calculation was made diving the organic layer and the reflective electrode into three parts, the electron injection/transport layer and the light-emitting layer, the hole injection/transport layer; and the translucent electrode. In the above graph, calculation was made for the electron injection/transport layer (thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm, refractive index of base material: 2.0), the scattering layer (thickness: 30 µm, refractive index of base material: 2.0, size of scattering material: 2 µm, refractive index of scattering material: 1.0, the number of scattering materials: about 36,000,000, content of scattering material: 15 vol%), the translucent substrate (thickness: 100 µm, refractive index: 1.54), and the light flux 1000 lm divided into 100,000 rays (wavelength: 550 nm). As shown in the graph, when the reflectivity of the cathode decreases, the light extraction efficiency also decreases. The cathode reflectivity of a blue LED is from 80% to 90%, so that it is seen that the light extraction efficiency of 40% to 50% is obtained. The reflectivity of Patent Document 1 is assumed to be 100%, and the light extraction efficiency thereof is about 50%. On the other hand, when the reflectivity of the present invention is taken as 100% and the same conditions as the reflectivity of Patent Document 1 are applied, the light extraction efficiency thereof exceeds 80% as seen from the graph. Namely, it is seen that the light extraction efficiency of the present invention is 1.6 times better than the light extraction efficiency of Patent Document 1. Accordingly, the organic LED of the present invention can be used as a light source for lighting in place of a fluorescent lamp.

### Refractive Indexes of Scattering Layer and Anode

Fig. 8 is a graph showing the relationship between the ratio of light outgoing to the scattering layer and the refractive index of the base material of the scattering layer. In the following, for simplicity, calculation was made diving the organic layer and the reflective electrode into three parts, the electron injection/transport layer and the light-emitting layer; the hole injection/transport layer, and the translucent electrode. In the above graph, calculation was made for the electron injection/transport layer (thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm), the scattering layer (thickness: 30 µm, size of scattering material: 2 µm, refractive index of scattering material: 1.0, the number of scattering materials: about 36,000,000, content of scattering material: 15 vol%), the translucent substrate (thickness: 100 µm, refractive index: 1.54), and the light flux 1000 lm divided into 100,000 rays (wavelength: 550 nm). As shown in the graph, when the refractive index of the anode is larger than the refractive index of the scattering layer, total reflection occurs on the surface of the scattering layer, and the amount entering the scattering layer decreases. Accordingly, it is seen that the light extraction efficiency decreases. Therefore, it is preferred that the refractive index of the scattering layer of the present invention is equivalent to or higher than the refractive index of the anode.

### Relationship Between Refractive Index of Base material of Scattering Layer and White Emitted Light Color

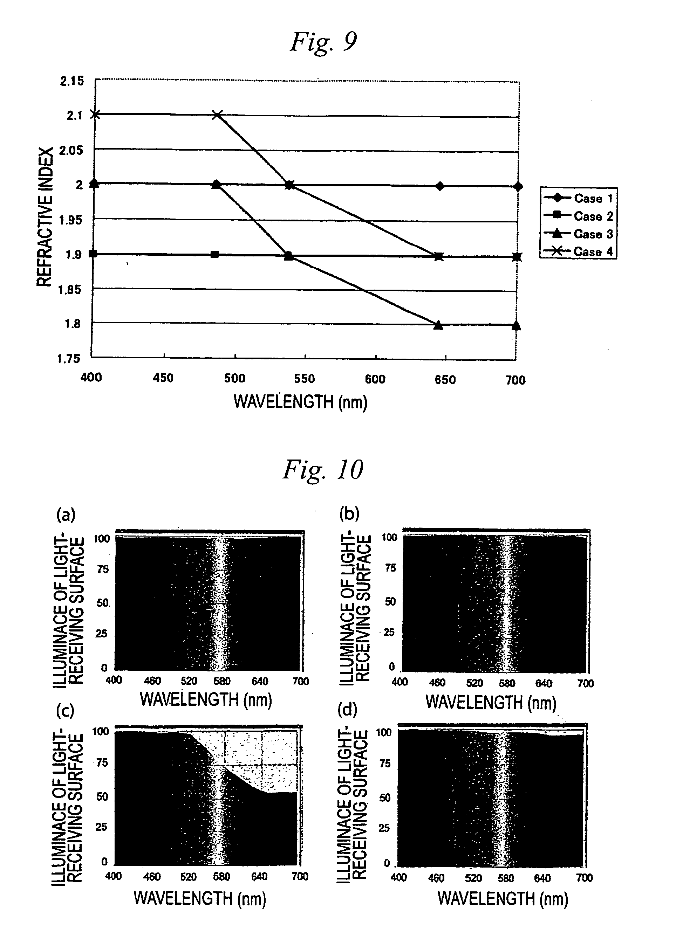

Fig. 9 is a graph showing the relationship between the wavelength and the refractive index of the base material of the scattering layer. Fig. 10 shows the results of the relationship between the wavelength and the illuminance of a light receiving surface. Fig. 10(a) is spectrum corresponding Case 1 of Fig. 9, Fig. 10(b) is spectrum corresponding Case 2 of Fig. 9, Fig. 10(c) is spectrum corresponding Case 3 of Fig. 9, and Fig. 10(d) is spectrum corresponding Case 4 of Fig. 9. In the following, for simplicity, calculation was made diving the organic layer and the reflective electrode into three parts, the electron injection/transport layer and the light-emitting layer; the hole injection/transport layer; and the translucent electrode. In the above graph, calculation was made for the electron injection/transport layer (thickness: 1 µm, refractive index: 1.9), the light-emitting layer (thickness: 1 µm, refractive index: 1.9), the hole injection/transport layer (thickness: 1 µm, refractive index: 1.9), the coating layer (thickness: 1 µm, refractive index of base material: 2.0), the scattering layer (thickness: 30 µm, refractive index of base material: 2.0, size of scattering material: 2 µm, refractive index of scattering material: 1.0, the number of scattering materials: about 36,000,000, content of scattering material: 15 vol%), the translucent substrate (thickness: 100 µm, refractive index: 1.54), and the light flux 1000 lm divided into 100,000 rays. The refractive index of the translucent electrode was 1.9. As shown in Fig. 10, when the refractive index of the base material of the scattering layer is lower than the refractive indexes of the organic layer and the translucent electrode, it is seen that the light extraction efficiency at its wavelength decreases, and color changes. Explaining specifically, it is seen that from Fig. 10(c) that when the wavelength is 550 nm or more, the emission efficiency decreases when the refractive index becomes 1.9 or less. In other words, the characteristic is deteriorated in red of the organic LED element. In this case, it is necessary to form an element having strong red as the constitution of an element.

### Measurement Methods of Refractive Index of Scattering Layer

There are the following two methods for measuring the refractive index of the scattering layer. One is a method of analyzing a composition of the scattering layer, preparing a glass having the same composition, and evaluating the refractive index by a prism method. The other is a method of polishing the scattering layer as thin as 1 to 2 µm, performing ellipsometry in a region of about 10 µm Φ in size having no pores, and evaluating the refractive index. In the present invention, it is assumed that the refractive index is evaluated by the prism method.

### Coating Layer

The coating layer is constituted of a single layer or a plurality of layers, and uses a material having high light transmittance. The material used as the coating layer is the same as the base material of the scattering layer, and a glass and a crystallized class are used. However, in addition to those, a translucent resin and a translucent ceramic can be used as the coating layer. Examples of the material of the glass include inorganic glasses such as soda lime glass, borosilicate glass, alkali-free glass and quartz glass. Similar to the scattering material, a plurality of scattering materials are formed in the scattering layer. Examples of the scattering material include pores, phase-separated glass and crystallized precipitates. When the coating layer is constituted of a single layer, it is preferable that solid particles are not used as the scattering material in order to prevent the solid particles from protruding from the surface of the coating layer. On the other hand, when the coating layer is constituted of a plurality of layers, there is no problem even though the solid particles are contained in layers other than a layer contacting with the translucent electrode. When at least the base layer of the scattering layer is constituted of the above glass, not only the glass and the crystallized glass, but a translucent resin and a translucent ceramic can be applied to the coating layer.

In order to realize an improvement of the light extraction efficiency which is the principal object of the present invention, it is preferred that the refractive index of the coating layer is equivalent to or higher than the refractive index of the translucent electrode material. The reason for this is that when the refractive index is low, loss due to total reflection occurs at the interface between the coating layer and the translucent electrode material. The refractive index of the coating layer is only required to exceed for at least one portion (for example, red, blue, green or the like) in the emission spectrum range of the light-emitting layer. However, it exceeds preferably over the whole region (from 430 nm to 650 nm) of the emission spectrum region, and more preferably over the whole region (from 360 nm to 830 nm) of the wavelength range of visible light. When the coating layer is a laminate comprising a plurality of layers, the laminate may be constituted such that the refractive indexes gradually increase with moving away from the translucent electrode. This constitution can inhibit loss by the total reflection. In this case, in order to obtain the extraction efficiency of 80% or more at the maximum, the difference between the refractive index of a layer contacting with the translucent electrode and the refractive index of the translucent electrode is preferably 0.2 or less.
Although both the refractive indexes of the coating layer and the scattering material in the coating layer may be high, the difference (Δn) in the refractive indexes is preferably 0.2 or more in at least one portion in the emission spectrum range of the light-emitting layer. The difference (Δn) in the refractive indexes is more preferably 0.2 or more over the whole region (from 430 nm to 650 nm) of the emission spectrum range or the whole region (from 360 nm to 830 nm) of the wavelength range of visible light.

In order to obtain the maximum refractive index difference, a constitution of using a high refractive index glass as the high light transmittance material and a gaseous material, namely pores, as the scattering material is desirable. The high refractive index glass containing one or two or more kinds of components selected from P₂O₅, SiO₂, B₂O₃, Ge₂O and TeO₂ as a network former and containing one or two or more kinds of components selected from TiO₂, Nb₂O₅, WO₃, Bi₂O₃, La₂O₃, Gd₂O₃, Y₂O₃, ZrO₂, ZnO, BaO, PbO and Sb₂O₃ as the high refractive index component is preferably used. In a sense of adjusting characteristics of the glass, an alkali oxide, an alkaline earth oxide, a fluoride or the like may be used within the range not impairing characteristics for the refractive index. Specific glass systems include a B₂O₃-ZnO-La₂O₃ system, a P₂O₅-B₂O₃-R'₂O-R"O-TiO₂-Nb₂O₅-WO₃-Bi₂O₃ system, a TeO₂-ZnO system, a B₂O₃-Bi₂O₃ system, a SiO₂-Bi₂O₃ system, a SiO₂-ZuO system, a B₂O₃-ZnO system, a P₂O₅-ZnO system and the like, wherein R' represents an alkyl metal element, and R" represents an alkaline earth metal element. The above systems are examples, and the glass system is not construed as being limited to these examples so long as it is constituted so as to satisfy the above-mentioned conditions.

It is possible to change color of light emission by allowing the coating layer to have a specific transmittance spectrum. As the colorant, a known colorant such as a transition metal oxide, a rare earth metal oxide and a metal colloid can be used singly or in combination thereof.
The surface of the coating layer is required to be smooth in order to prevent short circuit between electrodes of the organic LED. For the smoothness, the scattering material is not present on the surface of the coating layer, and the arithmetic average roughness on the surface of the coating layer defined in JIS B0601-1994 (hereinafter referred to as "surface roughness of the coating layer") Ra is preferably 30 nm or less, more preferably 10 nm or less, and particularly preferably 1 nm or less.

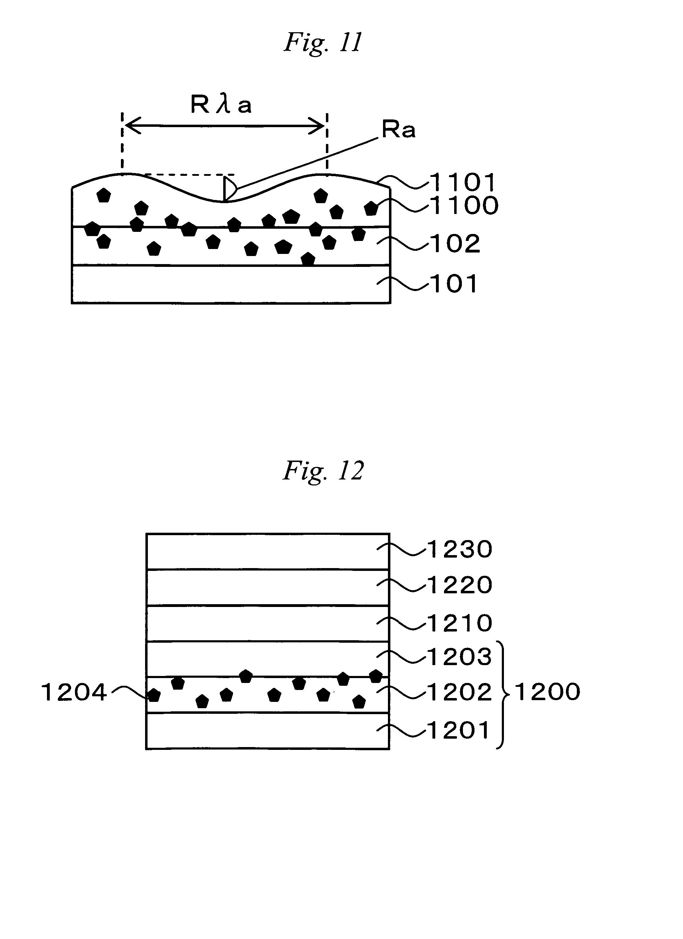

The surface of the coating layer may have waviness. The waviness differs from the surface roughness of the coating layer. The waviness means irregularities in the entire surface of the coating layer. On the other hand, the surface roughness of the coating layer means irregularities at a part of the surface of the coating layer. The waviness is described below by reference to the drawing. Fig. 11 is a cross-sectional view showing the coating layer having waviness. As shown in Fig. 11, a coating layer 1100 is formed on the scattering layer 101 formed on the translucent substrate 101. The surface of the coating layer 1100 has waviness 1101. The waviness 1101 has a period Rλa constituted of continuous one crest and one valley. Height difference between the crest and the valley is called waviness height Ra. The waviness period Rλa is preferably 10 µm or more, and more preferably 50 µm or more. The waviness height Ra is preferably from 0.01 µm to 5 µm. A ratio Ra/Rλa of the waviness height Ra to the waviness period λa preferably exceeds 1.0×10⁻⁴ and is 3.0×10⁻². When the ratio Ra/Rλa exceeds 1.5×10⁻⁴, it is advantageous to inhibit mirror reflectivity of the reflective electrode formed upper than the coating layer. When the ratio Ra/Rλa is 3.0×10⁻² or less, it is advantageous to uniformly form the translucent electrode formed on the coating layer.
The density ρ₂₁ of the scattering material at a half thickness (δ/2) of the coating layer and the density ρ₂₂ of the scattering material at a distance x (δ/2<x≤δ) from the back of the coating layer facing the scattering layer satisfy ρ₂₁≥ρ₂₂. Furthermore, the density ρ₂₃ of the scattering material at a distance x (x≤0.2 µm) from the valley of the waviness and the density ρ₂₄ of the scattering material at a distance x=2 µm satisfy ρ₂₄>ρ₂₃. A barrier film comprising at least one layer may be provided between the coating layer and the translucent electrode so long as it does not impair the object of the present invention. The barrier film is preferably a thin film containing at least one of oxygen and silicon. The thin film containing silicon or oxygen that can be used includes a silicon oxide film, a silicon nitride film, a silicon oxycarbide film, a silicon oxynitride film, an indium oxide film, a zinc oxide film, a germanium oxide film, and the like. Of those, considering translucency, a film comprising silicon oxide as a main component is more preferred.

### Translucent Electrode

The translucent electrode (anode) is required to have a translucency of 80% or more in order to extract the light generated in the organic layer to the outside. Furthermore, in order to inject many holes, one having high work function is required. Specifically, materials such as ITO (Indium Tin Oxide), SnO₂, ZnO, IZO (Indium Zinc Oxide), AZO (ZnO-Al₂O₃; zinc oxide doped with aluminum), GZO (ZnO-Ga₂O₃; zinc oxide doped with gallium), Nb-doped TiO₂ and Ta-doped TiO₂ are used. The thickness of the anode is preferably 100 nm or more. The refractive index of the anode is from 1.9 to 2.2. Increasing carrier concentration can decrease the refractive index of ITO. ITO is commercially available as a standard containing 10 wt% of SnO₂. The refractive index of ITO can be decreased by increasing the Sn concentration than this. However, although the carrier concentration is increased by an increase in the Sn concentration, the mobility and transmittance are decreased. It is therefore necessary to determine the Sn amount, achieving a balance of these.
It goes without saying that the translucent electrode may be used as the cathode.
A method for forming the translucent electrode is specifically described. ITO is film-formed on the substrate, and etching is applied to the ITO film, thereby forming the translucent electrode. ITO can be film-formed on the entire surface of the glass substrate with good uniformity by sputtering or vapor deposition. ITO pattern is formed by photolithography and etching. The ITO pattern becomes the translucent electrode (anode). A phenol-novolak resin is used as a resist, and exposure development is conducted. The etching can be either of wet etching and dry etching. For example, ITO can be subjected to patterning using a mixed aqueous solution of hydrochloric acid and nitric acid. For example, monoethanol amine can be used as a resist release material.

### Organic Layer

The organic layer comprises a hole injection layer, a hole transport layer, a light-emitting layer, an electron transport layer and an electron injection layer. The refractive index of the organic layer is from 1.7 to 1.8.
The organic layer is formed by a combination of a coating method and a vapor deposition method. For example, when one or more layers of the organic layers are formed by the coating method, other layers are formed by the vapor deposition method. When a layer is formed by the coating method and a layer is then formed on the layer by the vapor deposition method, condensation, drying and curing are conducted before forming the organic layer by the vapor deposition method.

### Hole Injection Layer

The hole injection layer is required to have small difference in ionization potential in order to lower a hole injection barrier from the anode. An improvement of a charge injection efficiency from an electrode interface in the hole injection layer decreases the driving voltage of the element and increase charge injection efficiency thereof. Polyethylenedioxythiophene doped with polystyrene sulfonic acid (PSS) (PEDOT:PSS) is widely used as a polymer, and copper phthalocyanine (CuPc) of the phthalocyaniene family is widely used as a low molecular substance.

### Hole Transport Layer

The hole transport layer plays a role to transport holes injected from the hole injection layer to the light-emitting layer. It is necessary to have appropriate ionization potential and bole mobility. Specifically, a triphenylamine derivative, N,N'-bis(1-naphthyl)-N,N'-diphenyl-1,1'- biphenyl-4,4'-diamine (NPD), N,N'-diphenyl-N,N'-bis[N- phenyl-N-(2-naphthyl)-4'-aminobiphenyl-4-yl]-1,1'-biphenyl-4,4'-diamine (NPTE), 1,1-bis[(di-4-tolylamino)phenyl]cyclohexane (HTM2), N,N'-diphenyl-N,N'-bis(3-methylphenyl)-1,1'-diphenyl, 4,4'-diamine (TPD) and the like are used as the hole transport layer. The thickness of the hole transport layer is preferably from, 10 nm to 150 nm. The thinner the thickness, the lower the voltage can be. However, the thickness of from 10 nm to 150 nm is particularly preferred in view of a problem of the interelectrode short circuit

### Light-Emitting Layer

The light-emitting layer provides a field in which injected electrons and holes recombine with each other, and uses a material having high emission efficiency. Describing in detail, a light-emitting host material and a doping material of a light-emitting dye, used in the light-emitting layer function as recombination centers of the holes and the electrons, injected from the anode and the cathode. Furthermore, doping of the host material in the light-emitting layer with the light-emitting dye provides high emission efficiency, and converts the light-emitting wavelength. Those are required to have a suitable energy level for charge injection, to be excellent in chemical stability and heat resistance, and to form a homogeneous amorphous thin film. Those are further required to be excellent in the kind of emission color and color purity, and to have high emission efficiency. The light-emitting material as the organic material includes low molecular materials and high molecular materials. Furthermore, those materials are classified into fluorescent materials and phosphorescent materials depending on the light-emitting mechanism. Specifically, the light-emitting layer includes metal complexes of quinoline derivatives, such as tris(8-quinolinolate)aluminum complex (Alq₃), bis(8-hydroxy)quinaldine aluminum phenoxide (Alq'₂OPh), bis(8-hyderoxy)quinaldine aluminum-2,5-dimethylphenoxide (BAlq), a mono(2,2,6,6-tetramethyl-3,5-heptanedionate)lithium complex (Liq), a mono(8-quinolinolate)sodium complex (Naq), a mono(2,2,6,6-tetramethyl-3,5-heptanedionate)lithium complex, a mono(2,2,6,6-tetramethyl-3,5-heptanedionate)sodium complex, and a bis(8-quinolinolate) calcium complex (Caq₂); and fluorescent substances such as tetraphenylbutadiene, phenylquinacridone (QD), anthracene, perylene and coronene. As the host material, a quinolinolate complex is preferred, and an aluminum complex having 8-quinolinol or a derivative thereof as a ligand is particularly preferred.

### Electron Transport Layer

The electron transport layer plays a role to transport holes injected from the electrode. Specifically, a quinolinol aluminum complex (Alq₃), an oxadiazole derivative (for example, 2,5-bis(1-naphthyl)-1,3,4-oxadiazole (BND), 2-(4-t-butylphenyl)-5-(4-biphenyl)-1,3,4-oxadiazole (PBD) or the like), a triazole derivative, a bathophenanthroline derivative, a silole derivative and the like are used as the electron transport layer.

### Electron Injection Layer

The electron injection layer which increases electron injection efficiency is required. Specifically, a layer doped with an alkali metal such as lithium (Li) or cesium (Cs) is provided on a cathode interface, as the electron injection layer.

### Reflective Electrode

A metal having small work function or an alloy thereof is used as the reflective electrode (cathode). Specifically, the cathode includes an alkali metal, an alkaline earth metal, and a metal of group 3 in the periodic table. Of those, aluminum (Al), magnesium (Mg), an alloy thereof and the like are preferably used for the reason that those are materials that are inexpensive and have good chemical stability. A co-vapor-deposited film of Al and MgAg, a laminated electrode in which Al is vapor-deposited on a thin vapor-deposited film of LiF, Li20 or the like, and the like are further used as the cathode. A laminate of calcium (Ca) or barium (Ba) and aluminum (Al), or the like is used as the cathode, in a system using a polymer. It goes without saying that the reflective electrode may be used as the anode.

### First Embodiment

The organic LED element of the first embodiment of the present invention is described below with reference to the drawing.
First, the structure of the organic LED element of the first embodiment of the present invention is described below with reference to the drawing. Fig. 12 is a cross-sectional view of the organic LED element of the first embodiment of the present invention.
The organic LED element of the first embodiment of the present invention comprises a laminate 1200 for an organic LED element, as a substrate for an electronic device, a translucent electrode 1210, an organic layer 1220 and a reflective electrode 1230. The translucent electrode 1210 is formed on the laminate 1200 for an organic LED element. The organic layer 1220 is formed on the translucent electrode 1210. The reflective electrode 1230 is formed on the organic layer 1220. The laminate 1200 for an organic LED element comprises a translucent substrate 1201, a scattering layer 1202 and a coating layer 1203. The scattering layer 1202 contains a scattering material 1204, and is formed on the translucent substrate 1201. The coating layer 1203 is formed on the scattering layer 1202, and covers the scattering material 1204 protruded from a main surface of the scattering layer 1202.

### Second Embodiment

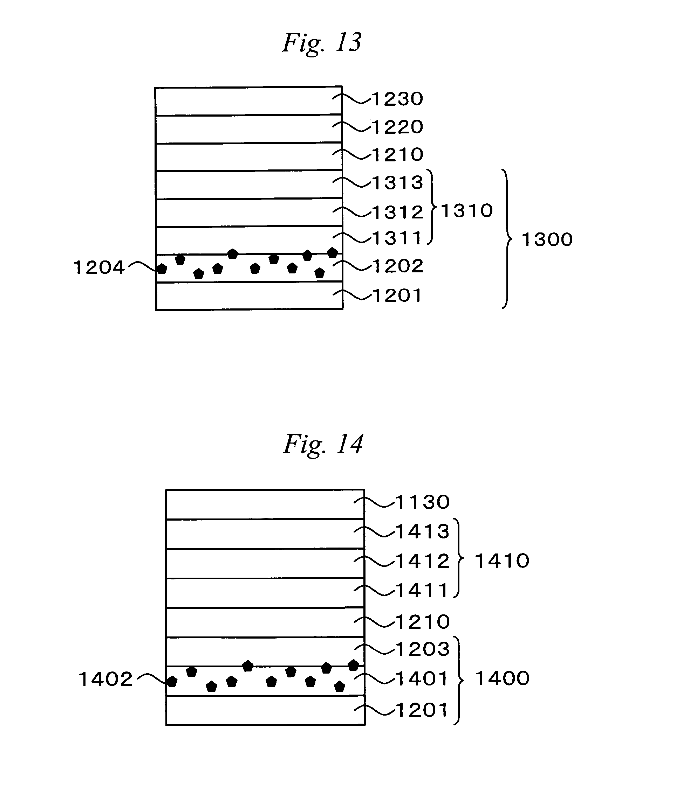

The organic LED element of the second embodiment of the present invention is described below with reference to the drawing. Fig. 13 is a cross-sectional view of the organic LED element of the second embodiment of the present invention. In the embodiments described below, the same reference numbers are given to the constitutional elements corresponding to the above-described embodiments, and the detailed descriptions thereof are omitted.
The organic LED element of the second embodiment of the present invention comprises a laminate 1300 for an organic LED element, as a substrate for an electronic device, the translucent electrode 1210, the organic layer 1220 and the reflective electrode 1230. The translucent electrode 1210 is formed on the laminate 1300 for an organic LED element. The laminate 1300 for an organic LED element comprises the translucent substrate 1201, the scattering layer 1202 and a coating layer 1310. The coating layer 1310 comprises a laminate of plural layers 1311, 1312 and 1313. In this case, considering an improvement of the light extraction efficiency, the laminate is constituted so as to satisfy the relationship of (refractive index of translucent electrode 1210)≤(refractive index of layer 1313)≤(refractive index of layer 1312) ≤(refractive index of layer 1311). The coating layer 1310 shown in Fig. 13 comprises three layers, but it goes without saying that the number of lamination is not limited to three. In this case, layers are constituted such that the refractive index is increased with increasing the distance from the translucent electrode 1210.

### Other Embodiments

Other constitutions of the laminate for an organic LED element of the present invention and the laminate for an organic LED element are described below with reference to the drawing. The same reference numbers are given to the constitutional elements corresponding to the above-described embodiments, and the detailed descriptions thereof are omitted. Fig. 14 is a cross-sectional view showing other structures of the laminate for an organic LED element of the present invention and the laminate for an organic LED element. The other organic LED element of the present invention comprises a laminate 1400 for an organic LED element, the translucent electrode 1210, an organic layer 1410 and the reflective electrode 1130. The laminate 1400 for an organic LED element comprises the translucent electrode 1201, a scattering layer 1401 and the coating layer 1203. The organic layer 1410 comprises a hole injection/transport layer 1411, a light-emitting layer 1412, and an electron injection/transport layer 1413.
The light-emitting layer of the organic LED element of the above-described embodiment comprises two layers. Any one of the two layers is formed so as to emit any one color of two emission colors (red and green). However, the light-emitting layer 1412 of the organic LED element of this embodiment can be constituted of one layer emitting only blue light by using a fluorescent emission material (for example, a filler) emitting red light and green light as a plurality of scattering materials 1402 provided in the inside of the scattering layer 1401. Namely, according to the other constitution of the organic LED element of the present invention, a layer emitting any one color of blue, green and red can be used as the light-emitting layer to achieve an effect that the organic LED element can be downsized.

In the above embodiments, descriptions have been made for the constitution in which the organic layer is sandwiched between the translucent electrode and the reflective electrode. However, a bifacial light transmission type organic LED layer may be constituted by making both electrodes translucent.
The substrate for an electronic device (laminate for an organic LED element) of the present invention is effective to increase the efficiency of optical devices such as various light-emitting devices such as inorganic LED elements and liquid crystal; and light-receiving devices such as light quantity sensors and solar cells, without being limited to the organic LED elements.
In particular, there are following effects in solar cells. In the case of the solar cells, it is necessary that a translucent electrode, a photoelectric conversion layer and a metal layer are formed on the substrate for an electronic device, and additionally, light-collecting electrodes for contacting with the translucent electrode are provided in given intervals. However, the surface is smooth due to the presence of the coating layer. Therefore, it is possible to increase reliability while decreasing the film thickness of the translucent electrode as thin as possible and improving translucency. The presence of the scattering layer can efficiently lead light entering a region light-shielded by the light-collecting electrodes to a region free of the light-collecting electrodes, thereby performing photoelectric conversion in the photoelectric conversion layer. As a result, the emission efficiency can greatly be improved.

### EXAMPLES

### Simulation Result

Example 1 is an organic LED element having the scattering layer of the present invention, and Comparative Example 2 is an organic LED element that does not have a coating layer and a scattering layer.

### Calculation Method

In order to obtain the characteristics of the scattering layer, the present inventors have conducted optical simulations, and examined the influences exerted on the extraction efficiency for respective parameters. A computing software used is a software SPEOS, manufactured by OPTIS Corporation. This software is a ray trace software, and at the same time, it is possible to apply a theoretical formula of Mie scattering to the scattering layer. The thickness of the organic layer actually used is actually from about 0.1 µm to 0.3 µm in total. However, in the ray trace, the angle of a ray does not change even when the thickness is changed. From this fact, it was taken as 1 µm of the minimum thickness allowed in the software. For a similar reason, the thickness of the glass was taken as 100 µm. For simplicity, calculation was made dividing the organic layer and the translucent electrode into three parts, the electron injection/transport layer and the light-emitting layer; the hole injection/transport layer; and the translucent electrode. In the calculation, the refractive indexes of those are assumed as the same. However, the refractive indexes of the organic layer and the translucent electrode are equivalent value, so that the calculated results are not greatly changed. Further, the organic layer is thin. Therefore, strictly considering, waveguide mode caused by interference stands. However, the results are not largely changed even when geometric-optically treated. This is therefore sufficient to estimate the advantages of the present invention by calculation. In the organic layer, emitted light is assumed to be outgone from a total of 6 faces without having directivity. Calculation was made, taking the total light flux amount as 1,000 lm, and the number of light rays as 100,000 rays or 1,000,000 rays. The light outgone from the translucent substrate is captured on a light receiving surface provided 10 µm above the translucent substrate, and the extraction efficiency was calculated from the illuminance thereof.
The respective conditions and results (front extraction efficiency) are shown in Table 1 below.

**TABLE 1**

| | Example 1 | Comparative Example 2 |
|---|---|---|
| Electron injection/transport layer | | |
| Thickness (µm) | 1 | 1 |
| Refractive index | 1.9 | 1.9 |
| Light-emitting layer | | |
| Thickness (µm) | 1 | 1 |
| Refractive index | 1.9 | 1.9 |
| Hole injection/transport layer | | |
| Thickness (µm) | 1 | 1 |
| Refractive index | 1.9 | 1.9 |
| Coating layer | | |
| Base material | | |
| Thickness (µm) | 1 | - |
| Refractive index | 1.9 | - |
| Transmittance (%) | 100 | - |
| Scattering material | - | - |
| Scattering layer | | |
| Base material | | |
| Thickness (µm) | 30 | 30 |
| Refractive index | 1.9 | 1.9 |
| Transmittance (%) | 100 | 100 |
| Scattering material | | |
| Size (µm) | 5 | - |
| Refractive index | 1 | - |
| Number of particles (@1 mm²) | 1527932.516 | - |
| Content (vol%) | 10 | - |
| Transmittance (%) | 100 | - |
| Translucent substrate | | |
| Thickness (µm) | 100 | - |
| Refractive index | 1.54 | - |
| Light flux | | |
| Number of light rays extracted from front face | 811.1/1000 | 210.4/1000 |
| Number of light rays extracted from side face | 47.86/1000 | 125/1000 |
| Front extraction efficiency (%) | 81.11 | 21,04 |

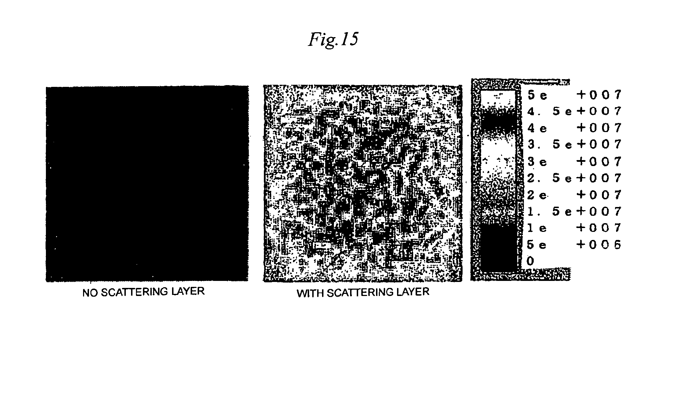

The results of the front extraction efficiency of the example and the comparative example are shown in Fig. 15. Fig. 15 is a view showing the results of observation from the front under the conditions of Example 1 and Comparative Example 2. As shown in Fig. 15, use of the coating layer and the scattering layer makes it possible to improve the light extraction efficiency which is about 20% when untreated to about 80%.

### Confirmation of Coating

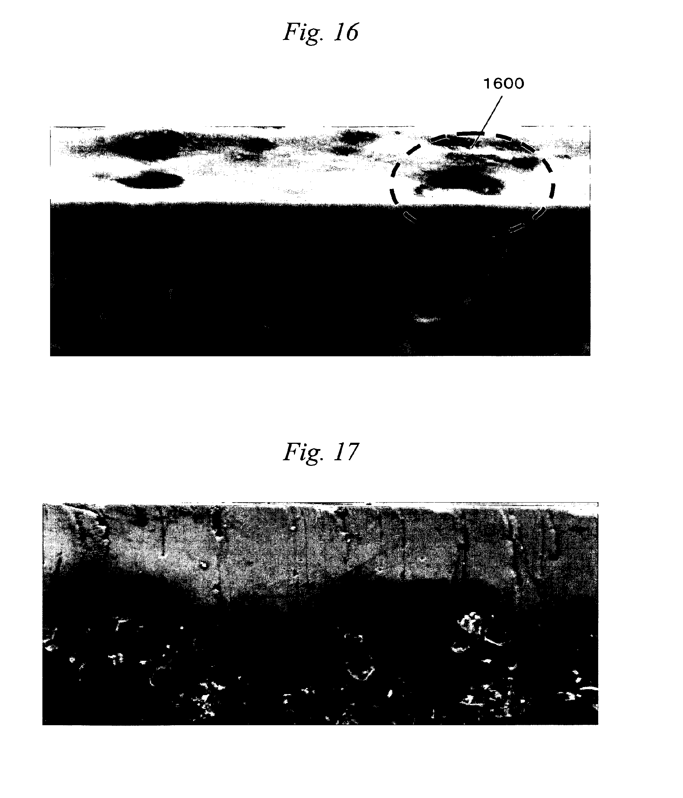

Experimental results confirming that the solid scattering particles protruded from the surface of the scattering layer are covered with the coating layer are shown below.
First, a substrate was prepared. PD200, manufactured by Asahi Glass Co., Ltd. was used as the substrate. This glass has a strain point of 570°C and a thermal expansion coefficient of 83×10⁻⁷ (1/°C). The glass substrate having such high strain point and high thermal expansion coefficient are suitable in the case of forming a scattering layer by firing a glass frit paste. Next, a glass material for a scattering layer was prepared. Raw materials were mixed and melted such that the glass composition becomes the composition of the scattering layer shown in Table 2, and cast on a roll, thereby obtaining a flake. The refractive index of this glass was 1.73 at d-ray (587.56 nm). The flake obtained was pulverized to obtain a glass powder. This glass powder and a YAG:Ce⁺³ fluorescent material (P46-Y3, weight central particle diameter: 6.6 µm, manufactured by Kasei Optonix Co., Ltd.) were kneaded together with an organic vehicle (prepared by dissolving about 10 mass% of ethyl cellulose in α-terpineol or the like) to prepare a paste ink (glass paste). This glass paste was printed on the glass substrate in a film thickness after firing of 30 µm, followed by drying at 150°C for 30 minutes. Temperature was once returned to room temperature, and increased to 450°C over 45 minutes. The temperature was held for 30 minutes, and then increased to 620°C over 17 minutes. The temperature was held for 30 minutes, and then returned to room temperature over 3 hours. Thus, the YAG:Ce⁺³ fluorescent material dispersion layer could be formed. In this case, the YAG:Ce⁺³ has the refractive index of 1.83 which differs from the refractive index of the glass, and therefore acts as solid scattering particles. This photograph is shown in Fig. 16. It is seen that a part of YAG:Ce⁺³ dispersed in the glass layer exposes on the surface of the glass layer (see 1600 in the drawing). When the organic LED element is formed thereon, short circuit may occur between electrodes due to the irregularities. A glass becoming a glass composition shown in the coating layer of Table 2 was prepared on the substrate. The refractive index of this glass was 1.72 at d-ray (587.56 nm). Thereafter, the glass power and the glass paste were prepared in the same manners as above. This glass paste was uniformly printed on the YAG:Ce⁺³ fluorescent material dispersion layer in a film thickness after firing of 30 µm, followed by drying at 150°C for 30 minutes. Temperature was once returned to room temperature, and increased to 450°C over 45 minutes. The temperature was held for 30 minutes, and then increased to 620°C over 17 minutes. The temperature was held for 30 minutes, and then returned to room temperature over 3 hours. Thus, a laminate comprising the YAG:Ce⁺³ fluorescent material dispersion layer having the coating layer formed thereon could be obtained. This photograph is shown in Fig. 17. Thus, the YAG:Ce⁺³ fluorescent material does not expose on the outermost surface of the coating layer, and a smooth surface is obtained. In this case, there are no irregularities as appeared in the above example. As a result, even though the organic LED element is prepared thereon, short circuit does not occur between electrodes.

**TABLE 2**

| | Coating layer (mol%) | Scattering layer (mol%) |
|---|---|---|
| SiO₂ | 15.2 | 15 |
| B₂O₃ | 30.2 | 30.5 |
| ZnO | 25.3 | 33 |
| Al₂O₃ | 3,6 | 0 |
| TiO₃ | 2.1 | 0 |
| BaO | 12.0 | 11 |
| Bi₂O₃ | 8.6 | 8.8 |
| Li₂O | 2.8 | 0 |
| CeO₂ | 0.2 | 0.1 |
| MnO₂ | 0 | 0.1 |
| Tg (°C) | 472 | 493 |
| At (°C) | 579 | 589 |
| Expansion coefficient (10⁻⁷°C⁻¹) | 79 | 79 |
| Specific gravity | 4.5 | 4.7 |

The refractive index was measured with a refractometer (trade name: KRP-2, manufactured by Kalnew Optical Industrial Co., Ltd.). The glass transition point (Tg) and yield point (At) were measured by a thermal expansion method using a thermal analysis equipment (trade name: TD5000SA, manufactured by Bruker) in a temperature rising rate of 5°C/min.

### Confirmation of Improvement of Light Extraction Efficiency

The above-described glass substrate (PD200, manufactured by Asahi Glass Co., Ltd.) was used as a substrate.
A scattering layer was prepared by a method described hereinafter. Raw materials were mixed and melted such that the glass composition becomes the composition shown in Table 2, and cast on a roll, thereby obtaining a flake. The refractive index of this glass was 1.72 at d-ray (587.56 nm). The flake obtained was pulverized to obtain a glass powder. The size of the glass powder was 2.62 µm in D50. This glass powder and silica spheres SO-C6 (average particle size: 2.2 µm) manufactured by Admafine were kneaded together with an organic vehicle (prepared by dissolving about 10 mass% of ethyl cellulose in α-terpineol or the like) to prepare a paste ink (glass paste). This glass paste was uniformly printed on the glass substrate in a circle shape having a diameter of 10 mm such that a film thickness after firing is 30 µm, followed by drying at 150°C for 30 minutes. Temperature was once returned to room temperature, and increased to 450°C over 45 minutes. The temperature was held for 30 minutes, and then increased to 620°C over 17 minutes. The temperature was held for 30 minutes, and then returned to room temperature over 3 hours. Thus, a plurality of the scattering layer-attached substrates in which particles are protruded from the surface thereof were prepared.

Next, a coating layer was prepared on one scattering layer-attached substrate. The coating layer was prepared in the same composition and manner as the coating layer of Table 2, except that the above-described silica spheres are not contained in the glass powder. Similar to the above, the glass paste obtained was printed on the glass substrate in a circle shape having a diameter of 10 mm such that a thickness is 21 µm, followed by drying at 150°C for 30 minutes. Temperature was once returned to room temperature, and increased to 450°C over 45 minutes. The temperature was held for 30 minutes, and then increased to 620°C over 17 minutes. The temperature was held for 30 minutes, and then returned to room temperature over 3 hours. Thus, the substrate having attached thereto a coating layer which covers the scattering layer having particles protruded from the surface thereof was prepared.
For convenience of the explanation, a substrate which does not have a coating layer and a scattering layer is called a "substrate", a substrate in which a scattering layer having particles protruded from the surface thereof is not covered with the scattering layer is called a "coating layer-free substrate", and a substrate having a coating layer which covers a scattering layer having particles protruded from the surface thereof is called "a coating layer-attached substrate".

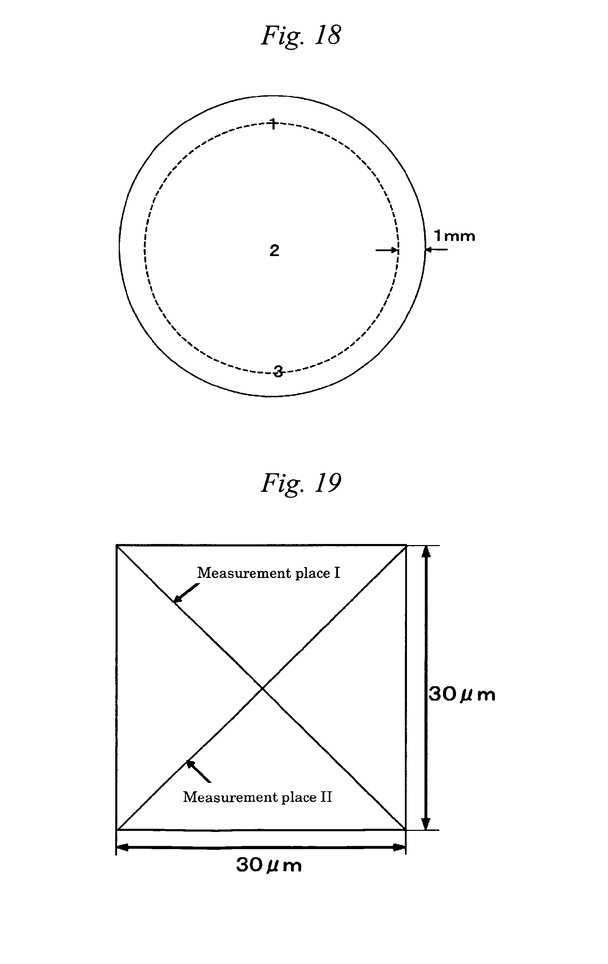

Surface roughness of the coating layer-free substrate and the coating layer-attached substrate was measured. Three-dimensional non-contact profilometer Micromap, manufactured by Ryoka Systems Inc., was used for the measurement. The measurement was made at three places of a circular light scattering layer shown in Fig. 18, and the measurement region was 900 µm². Roughness in one region was measured by two diagonal lines (42.3 µm) as shown in Fig. 19. Cut-off wavelength of waviness was 10 µm. The measurement results of the coating layer-free substrate are shown in Table 3, and the measurement result of the coating layer-attached substrate are shown in Table 4. Thus, the face contacting with the translucent electrode could be smoothened by providing the coating layer.

**TABLE 3**

| Measurement position | Measurement line | Ra (nm) |
|---|---|---|
| 1 | I | 13.50 |
| | II | 15.49 |
| 2 | I | 20.00 |
| | II | 11.84 |
| 3 | I | 12.28 |
| | II | 33.54 |

**TABLE 4**

| Measurement position | Measurement line | Ra (nm) |
|---|---|---|
| 1 | I | 0.39 |
| | II | 0.48 |
| 2 | I | 0.42 |
| | II | 0.47 |
| 3 | I | 0.75 |
| | II | 0.76 |

The light extraction efficiency was measured.
In the following procedures, a substrate, a coating layer-free substrate and a coating layer-attached substrate were prepared, and OLED elements were prepared. ITO (Indium Tin Oxide) as a translucent conductive film was mask film-formed on a coating layer, a scattering layer and a substrate in a thickness of 150 nm by DC magnetron sputtering. The film-formed ITO had a width of 2 mm and a length of 23 mm. Ultrasonic washing using pure water was performed, and irradiation with ultraviolet rays was then performed using an excimer UV equipment to clean the surface. α-NPD(N,N'-diphenyl-N,N'-bis(α-naplathyl-1,1'-biphenyl-4,4'-diamine), Alq₃(tris 8-hydroquinoline aluminium), LiF and Al were vapor-deposited in thicknesses of 100 nm, 60 nm, 0.5 nm and 80 nm, respectively, using a vacuum vapor deposition apparatus. In this case, α-NPD and Alq₃ formed a circular pattern having a diameter of 12 mm using a mask, and LiF and Al formed a pattern using a mask having a width of 2 mm crossing the ITO pattern. Thus, an element was completed Immediately after, characteristics were evaluated.

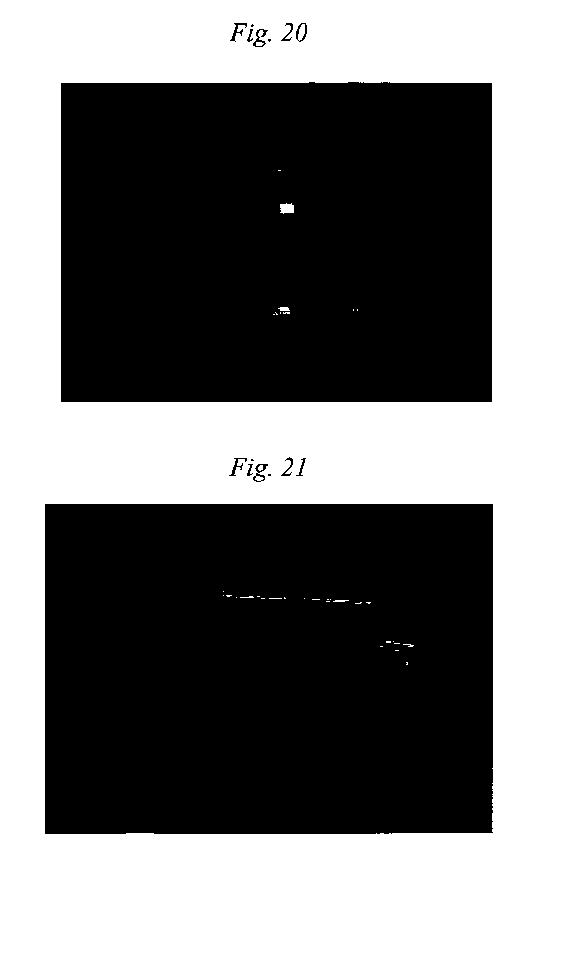

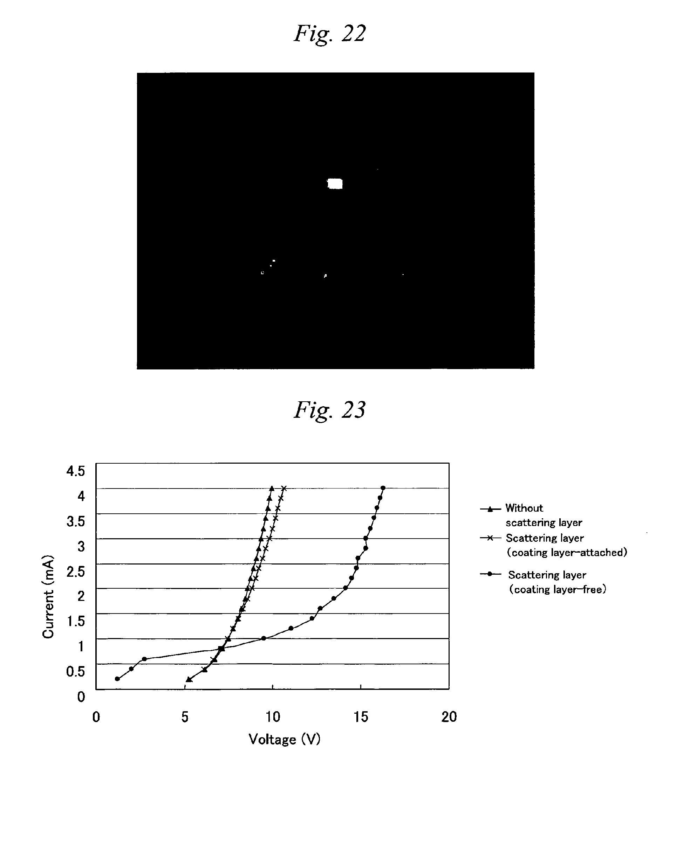

Results of the characteristic evaluation are explained below using the drawings. The states of emission when 0.6 mA was applied are shown in Fig. 20 to Fig. 22. Fig. 20 is a photograph showing the emission state of the light-emitting element comprising the organic LED element that does not have a scattering layer and a coating layer. As is apparent from the drawing, it was confirmed that the light-emitting element that does not have the scattering layer and the coating layer is emission only at the portion (2mm□) at which ITO and Al overlapped. Fig. 21 is a photograph showing the emission state of the light-emitting element that does not have a coating layer and has a scattering layer having particles protruded from the surface thereof. As is apparent from the drawing, it was confirmed that the light-emitting element that has a scattering layer having particles protruded from the surface thereof but does not have a coating layer does not show emission. Fig. 22 is a photograph showing the emission state of the light-emitting element that has a scattering layer and a coating layer. As is apparent from the drawing, the light-emitting element that has a scattering layer and a coating layer confirmed emission in the entire scattering layer in addition to a portion (2mm□) at which ITO and Al overlapped.

The relationship between the voltage and the current is shown in Fig. 23. As shown in Fig. 23, the current/voltage characteristics of the scattering layer-free element nearly coincide with those of the element having a coating layer and a scattering layer, whereas leakage at a low voltage region and high resistance at a high voltage side are observed in the coating layer-free element. In the coating layer-free element, silica particles in the scattering layer are exposed on the surface thereof. Therefore, it is considered that interelectrode leakage occurs in a low voltage region, and thereafter, the leakage part is broken by joule heat in high voltage state, thereby increasing resistance. On the other hand, from the fact that the current/voltage characteristics of the element formed on the scattering layer having the coating layer nearly coincide with those of the scattering layer-free element, it is seen that leakage current in the element having a coating layer on a scattering layer is inhibited equivalent to the scattering layer-free element.

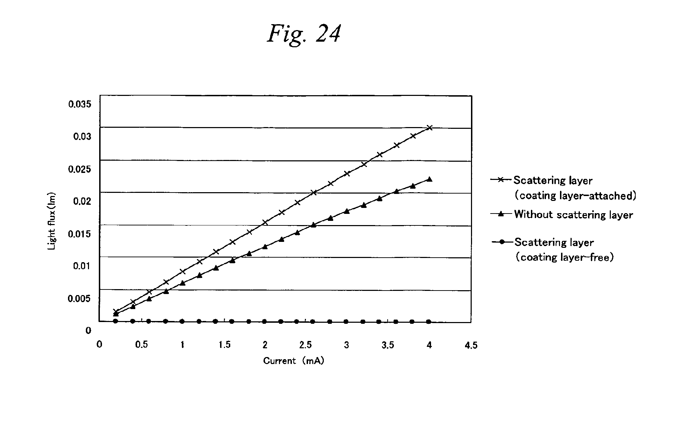

Current luminance characteristics were measured. Fig. 24 is a graph showing the relationship between the current and the light flux. As shown in Fig. 24, in the case of the element having a scattering layer that is not covered with a coating layer, emission was not seen. On the other hand, in the case of the element having a scattering layer covered with a coating layer and the element which does not have a scattering layer and a coating layer, the luminance was proportional to a current value. Current efficiency of the element having a coating layer was 2.44 cd/A, and current efficiency of the element which does not have a scattering layer and a coating layer was 1.85 cd/A. Therefore, it was seen that the light extraction efficiency of the element having a scattering layer was improved 1.3 (=2.44/1.85) times as compared with the light extraction efficiency of the element that does not have a scattering layer and a coating layer.
In the present experiments, slight coloration was seen in the material used in the scattering layer. According to the experiences of the present inventors, it is considered that the light extraction efficiency can further be improved by improving coloration.

### Confirmation of Reduction of Specular Reflection

Experimental results confirming that specular reflection by a reflective electrode was reduced by using a coating layer having waviness are shown.
Waviness and reflection were evaluated using eight kinds of samples having different waviness. Waviness was evaluated by measuring with SURFCOM 1400D, manufactured by Tokyo Seimitsu Co., Ltd., using a scattering layer-attached glass substrate. Long wavelength cut-off value was 2.5 mm.
Because the scattering layer is formed just above the scattering layer, the shape of the coating layer and the shape of the scattering layer are nearly the same. In other words, when the scattering layer has waviness, the coating layer has the same waviness. For this reason, in this experiment, judgment was made using the scattering layer having waviness, not the coating layer having waviness.

### First, a glass substrate was prepared.

Next, glasses having four different compositions were prepared as scattering layers. A scattering layer-attached glass substrate A used was that the scattering layer has a glass composition comprising 23.1% of P₂O₅, 12% of B₂O₃, 11.6% of Li₂O, 16.6% of Bi₂O₃, 8.7% of TiO₂, 17.6% of Nb₂O₅ and 10.4% of WO₃, in terms of mol%. Glass transition temperature Tg of the scattering layer-attached glass substrate A was 499°C. A scattering layer-attached glass substrate B was that the scattering layer has a glass composition comprising 23.1% of P₂O₅, 5.5% of B₂O₃, 11.6% of Li₂O, 4% of Na₂O₃, 2.5% of K₂O, 16.6% of Bi₂O₃, 8.7% of TiO₂, 17.6% of Nb₂O₅ and 10.4% of WO₃, in terms of mol%. Glass transition temperature Tg of the scattering layer-attached glass substrate B was 481°C. A scattering layer-attached glass substrate C used was that the scattering layer has a glass composition comprising 5.1% of SiO₂, 24.4% of B₂O₃, 52.37% of Pb₃O₄, 7.81% of BaO, 6.06% of Al₂O₃, 2.71% of TiO₂, 0.41% of CeO₂, 0.48% of Co₃O₄, 0.56% of MnO₂ and 0.26% of CuO, in terms of mol%. Glass transition temperature Tg of the scattering layer-attached glass substrate C was 465°C. A scattering layer-attached glass substrate D used was that the scattering layer has a glass composition comprising 15.6% of P₂O₅, 3.8% of B₂O₃, 41.8% of WO₃, 13.5% of Li₂O, 8.6% of Na₂O₃, 2.3% of K₂O and 14.4% of BaO, in terms of mol%. Glass transition temperature Tg of the scattering layer-attached glass substrate A was 445°C.
Using the above glasses, each glass was processed into a glass powder. The glass powder was mixed with a resin to prepare a paste. The paste was printed on the glass substrate, followed by firing at from 530 to 580°C. Thus, by adjusting the firing conditions, seven kinds of scattering layer-attached glass substrates having different waviness roughness Ra and waviness wavelength Rλa were prepared. For the sake of comparison, a flat glass plate which does not have a scattering layer was prepared.

One prepared by film-forming Al in a thickness of 80 nm on the scattering layer-attached glass substrate by vacuum vapor deposition was used as a sample for reflection evaluation. The structure of the original organic LED element is that a translucent electrode is laminated on a scattering layer, an organic layer such as a hole transport layer/light-emitting layer/electron transport layer, or the like is laminated thereon, and an Al layer as an electrode is laminated thereon. In this experiment, because the sample is for visual evaluation, a translucent electrode and an organic layer are omitted. The organic layer has a total thickness of a few hundred nm, and follows up irregularities of the scattering layer. Therefore, the presence or absence of the layer does not affect waviness on the surface. Therefore, omission of the layer does not give rise to any problem.
Method for reflection evaluation was that a core having a diameter of 0.5 mm of a mechanical pencil is placed on an evaluation sample with a distance of about 5 mm, and it is judged as to whether an image of the core reflected on Al surface is seen distorted. This evaluation was conducted with six persons a to f.
The evaluation results were that when the core of a mechanical pencil is seen distorted, it is indicated as "O", when the core is seen straight without distortion, it is indicated as "×", and when judgment is difficult, it is indicated as "△".
The results are shown in Table 5.

**TABLE 5**

| No. | Scattering layer glass | Firing temperature | Waviness evaluation | | | Reflection (mirror reflectivity) evaluation | | | | | |
|---|---|---|---|---|---|---|---|---|---|---|---|
| | | | Ra (µm) | Rλa (µm) | Ra/Rλa | a | b | c | d | e | f |
| 1 | A | 550°C | 3.438 | 152 | 0.0226 | ○ | ○ | ○ | ○ | ○ | ○ |
| 2 | A | 560°C | 2.571 | 215 | 0.0120 | ○ | ○ | ○ | ○ | ○ | ○ |
| 3 | A | 570°C | 2.441 | 236 | 0.0103 | ○ | ○ | ○ | ○ | ○ | ○ |
| 4 | B | 550°C | 4.361 | 457 | 0.0095 | ○ | ○ | ○ | ○ | ○ | ○ |
| 5 | A | 580°C | 1.663 | 298 | 0.0056 | ○ | ○ | ○ | ○ | ○ | ○ |
| 6 | D | 530°C | 0.331 | 335 | 0,0010 | ○ | ○ | ○ | ○ | ○ | ○ |
| 7 | C | 550°C | 0.028 | 140 | 0.0002 | ○ | ○ | ○ | ○ | △ | ○ |
| 8 | Glass substrate | | 0.001 | 6 | 0.0001 | × | × | × | × | × | × |

As is seen form Table 5, all persons judged that the core of a mechanical pencil is seen distorted in Sample Nos. 1 to 7 as compared with Sample No. 8 as the comparative example. This could confirmed the fact that reflection is reduced when a ratio Ra/Rλa of waviness height Ra to waviness period Rλa exceeds 1.0×10⁻⁴ and is 3.0×10⁻² or less. Namely, it was seen that reflection, that is, mirror reflectivity, can be reduced by waviness.
In Table 5, when Rλa is large to such an extent that the ratio Ra/Rλa of waviness height Ra to waviness period Rλa is less than 1.0×10⁻⁴, or the waviness height Ra is small, the reflection cannot sufficiently be reduced. At the same time, the waviness period Rλa is desirable to be larger than about 50 µm, considering resolution of human eyes. In fact, in the glass substrate of Sample No. 8, the ratio Ra/Rλa is 1.0×10⁻⁴, and is within the above range, but Rλa is small as 6 λm, and cannot be visualized by human eyes. Therefore, the reflection cannot be reduced.

Further, when the waviness roughness Ra is large to such an extent that the ratio Ra/Rλa exceeds 3.0×10⁻², an electrode or an organic layer cannot uniformly be film-formed. As a result, it is difficult to form a device.
Therefore, as described above, it is desirable to be Rλa>50 µm and Ra/Rλa=exceeding 1.0×10⁻⁴ and 3.0×10⁻² or less. Furthermore, even when Rλa>10 µm and Ra/Rλa=1.0×10⁻⁵ to 1.0×10⁻¹, the reflection, namely, mirror reflectivity, can nearly be reduced.
Diffusion reflection ratio was measured on the samples shown in Table 5.
LANBDA 950, manufactured by PERKIN ELMER, was used for the measurement.
As a result of measurement of Sample Nos. 1 to 6, the diffusion reflection ratio of Sample No. 1 was 98%, the diffusion reflection ratio of Sample No. 2 was 85%, the diffusion reflection ratio of Sample No. 3 was 83%, the diffusion reflection ratio of Sample No. 4 was 72%, the diffusion reflection ratio of Sample No. 5 was 60%, and the diffusion reflection ratio of Sample No. 6 was 43%. When the respective diffusion reflection ratios were rounded to the nearest 10, all of the samples exceeded 40%. Accordingly, it is seen that the reflection can be reduced. Therefore, nearly the same results as the evaluation results of mirror reflectivity were obtained in the results of diffusion reflection ratio.

As described above, when a reflective electrode is used, reflection may occur by specular reflection of the reflective electrode at the time of non-light emission, resulting in deterioration of the appearance. The reflection could be inhibited by using the coating layer having waviness of the present invention.
According to the present invention, it is possible to provide an electronic device including an organic LED element having a large effective area, which inhibits interelectode short circuit of an electronic device formed on the surface and has a long life.
Furthermore, it is possible to provide a substrate for an electronic device containing a laminate for an organic LED element having excellent scattering property, that can realize stability and high strength by constituting a scattering layer with a glass, without increasing a thickness as compared with the original translucent substrate comprising a glass.
In the above description, all of the structures described regarding the laminate for an organic LED element can be applied to various substrates for an electronic device including solar cells and inorganic EL elements.

The present application is based on Japanese Patent Application No. 2008-069841 filed on March 18, 2008 and Japanese Patent Application No. 2008-304183 filed on November 28, 2008, the disclosures of which are incorporated herein by reference in their entities.

## Claims

1. A substrate for an electronic device, comprising:
a translucent substrate,
a scattering layer comprising a glass, provided on the translucent substrate,
a coating layer provided on the scattering layer, and
scattering materials that are present in the scattering layer and the coating layer and are not present on a surface of the coating layer.

2. The substrate for an electronic device according to claim 1, wherein a surface of the coating layer has waviness in which a ratio Ra/Rλa of waviness height Ra to waviness period Rλa exceeds 1.0×10⁻⁴ and is 3.0×10⁻² or less.

3. The substrate for an electronic device according to claim 1 or 2, wherein the scattering materials are pores.

4. A laminate for an organic LED element comprising:
a translucent substrate,
a scattering layer comprising a glass, provided on the translucent substrate,
a coating layer provided on the scattering layer, and
a plurality of scattering materials that are present across an interface between the scattering layer and the coating layer and do not protrude from a main surface of the coating layer.

5. The laminate for an organic LED element according to claim 4, wherein an arithmetic average roughness of the main surface of the coating layer is smaller than an arithmetic average roughness of a main surface of the scattering layer facing the coating layer.

6. The laminate for an organic LED element according to claim 3 or 4, wherein the arithmetic average roughness of the main surface of the coating layer is 30 nm or less.

7. A laminate for an organic LED element comprising:
a translucent substrate,
a scattering layer comprising a glass, having a main surface having a first arithmetic average roughness, and being provided on the translucent substrate, and
a coating layer having a main surface having a second arithmetic average roughness smaller than the first arithmetic average roughness, and being provided on the main surface of the scattering layer.

8. The laminate for an organic LED element according to any one of claims 4 to 6, wherein a refractive index of the coating layer is 1.7 or more in at least one wavelength of wavelengths of emitted light of a light-emitting device to be mounted on the laminate for an organic LED element.

9. The laminate for an organic LED element according to any one of claims 4 to 8, wherein a refractive index of the scattering layer is larger than the refractive index of the refractive index of the coating layer.

10. The laminate for an organic LED element according to any one of claims 4 to 8, wherein a refractive index of the scattering layer is the same as the refractive index of the refractive index of the coating layer.

11. The laminate for an organic LED element according to any one of claims 4 to 10, wherein the scattering layer is a laminate comprising a plurality of layers.

12. The laminate for an organic LED element according to any one of claims 4 to 11, further comprising a translucent electrode layer provided on the main surface of the coating layer.

13. The laminate for an organic LED element according to claim 12, wherein the coating layer is a laminate comprising a plurality of layers such that refractive indexes thereof increases as a distance from the translucent electrode layer increases.

14. A process for producing a laminate for an organic LED element, comprising the steps of:
preparing a translucent substrate,
forming a scattering layer comprising a glass containing scattering materials on the translucent substrate, and
forming a coating layer that does not contain the scattering materials on the scattering layer.

15. The process for producing a laminate for an organic LED element according to claim 14, wherein the step of forming the scattering layer is a step of applying a frit paste containing the scattering material, followed by firing; or press bonding a green sheet containing the scattering material, followed by firing, and wherein the step of forming the coating layer includes a step of applying a frit paste which does not contain the scattering material, followed by firing; or press bonding a green sheet that does not contain the scattering material, followed by firing.

16. The process for producing a laminate for an organic LED element according to claim 15, wherein the firing steps in the step of forming the scattering layer and the step of forming the coating layer are simultaneously performed.

17. An electronic device comprising:
a translucent substrate,
a scattering layer comprising a glass, provided on the translucent substrate,
a coating layer provided on the scattering layer,
a translucent electrode layer provided on the coating layer,
a plurality of scattering materials that are present across an interface between the scattering layer and the coating layer and are not present across an interface between the translucent electrode layer and the glass layer, and
a functional layer provided on the translucent electrode layer.

18. An organic LED element comprising:
a translucent substrate,
a scattering layer comprising a glass, provided on the translucent substrate,
a coating layer provided on the scattering layer,
a translucent electrode layer provided on the coating layer,
a plurality of scattering materials that are present across an interface between the scattering layer and the coating layer and are not present across an interface between the translucent electrode layer and the glass layer,
an organic layer provided on the translucent electrode layer, and
a reflective electrode provided on the organic layer.

19. The organic LED element according to claim 18, wherein an arithmetic average roughness of a main surface of the coating layer contacting with the translucent electrode layer is smaller than an arithmetic average roughness of a main surface of the scattering layer contacting with the coating layer.

20. The organic LED element according to claim 18 or 19, wherein the arithmetic average roughness of the main surface of the coating layer is 30 nm or less.

21. An organic LED element comprising:
a translucent substrate,
a scattering layer comprising a glass, having a main surface having a first arithmetic average roughness, and being provided on the translucent substrate,
a coating layer having a main surface having a second arithmetic average roughness smaller than the first arithmetic average roughness, and being provided on the main surface of the scattering layer,
a translucent electrode layer provided on the main surface of the coating layer,
an organic layer provided on the translucent electrode layer, and
a reflective electrode provided on the organic layer.

22. A process for producing an organic LED element, comprising the steps of:
preparing a translucent substrate,
providing a scattering layer comprising a glass containing scattering materials on the translucent substrate,
providing a coating layer that does not contain the scattering materials on the scattering layer,
providing a translucent electrode layer on the coating layer,
providing an organic layer on the translucent electrode layer, and
providing a reflective electrode on the organic layer.

23. A laminate for an organic LED element, comprising
a translucent substrate,
a first layer provided on the translucent substrate,
a glass layer provided on the first layer, and
a plurality of scattering materials that are present across an interface between the first layer and the glass layer and do not protrude from a main surface of the glass layer.
